# EUROPEAN PATENT APPLICATION

(11) **EP 4 716 038 A1**
(43) Date of publication of application: **25.03.2026**
(21) Application number: 24810752.6
(22) Date of filing: 10.04.2024
(51) Int. Cl.: H01S 5/183, H01L 33/10, H01L 33/14, H01L 33/20, H01L 33/38, H01L 33/44

(54) **SURFACE LIGHT-EMITTING ELEMENT**

(30) Priority: 19.05.2023 JP 2023082742
(71) Applicant: Sony Semiconductor Solutions Corporation, Atsugi-shi, Kanagawa 243-0014 (JP)
(72) Inventor: SUBEDI, Bipin, Kikuchi-gun, Kumamoto 869-1102 (JP); YOKOTA, Tomohiro, Kikuchi-gun, Kumamoto 869-1102 (JP); ITO, Ryo, Kikuchi-gun, Kumamoto 869-1102 (JP); KUDO, Hiroki, Kikuchi-gun, Kumamoto 869-1102 (JP); KANEKO, Shingo, Kikuchi-gun, Kumamoto 869-1102 (JP); TACHIKAWA, Yoshiteru, Kikuchi-gun, Kumamoto 869-1102 (JP); AOYAGI, Hidekazu, Kikuchi-gun, Kumamoto 869-1102 (JP)
(74) Representative: D Young & Co LLP
(86) International application number: PCT/JP2024/014549
(87) International publication number: WO 2024/241744

(57) **Abstract**

To provide a surface-emitting element capable of improving stress resistance at a bottom portion of a mesa.

A surface-emitting element according to the present technology includes a first structure including a first semiconductor structure, a second structure including a second semiconductor structure stacked with the first structure, and a light-emitting layer arranged between the first and second structures and including a light-emitting region, in which a mesa including at least a part of the first semiconductor structure, the light-emitting layer, and the second semiconductor structure and having a bottom portion in the at least a part is formed, and an outer peripheral surface of the bottom portion has a convex portion that circles around the light-emitting region in plan view. With the surface-emitting element according to the present technology, a surface-emitting element capable of improving stress resistance at a bottom portion of a mesa can be provided.

## Description

### TECHNICAL FIELD

The technology according to the present disclosure (hereinafter also referred to as the "present technology") relates to a surface-emitting element.

### BACKGROUND ART

Conventionally, for example, surface-emitting elements capable of obtaining a surface-emission output, such as a surface-emitting laser and a light-emitting diode, are known.

Among the conventional surface-emitting elements, there are surface-emitting elements in which a step is provided on a side surface of a part of a mesa other than a bottom portion (for example, see Patent Document 1) and surface-emitting elements in which the entirety of a side surface of a mesa is inclined with respect to an emission direction (for example, see Patent Document 2).

### CITATION LIST

### PATENT DOCUMENT

Patent Document 1: WO 2017/212888 A
Patent Document 2: Japanese Patent Application Laid-Open No. 2010-114214

### SUMMARY OF THE INVENTION

### PROBLEMS TO BE SOLVED BY THE INVENTION

In the conventional surface-emitting elements, however, there is room for improvement in improving stress resistance at a bottom portion of a mesa.

It is therefore a main object of the present technology to provide a surface-emitting element capable of improving stress resistance at a bottom portion of a mesa.

### SOLUTIONS TO PROBLEMS

The present technology provides a surface-emitting element including:
a first structure including a first semiconductor structure;
a second structure including a second semiconductor structure stacked with the first structure; and
a light-emitting layer arranged between the first and second structures and including a light-emitting region, in which
a mesa including at least a part of the first semiconductor structure, the light-emitting layer, and the second semiconductor structure and having a bottom portion in the at least a part is formed, and
an outer peripheral surface of the bottom portion has a convex portion that circles around the light-emitting region in plan view.

A height of the bottom portion may be 1/3 or less of a height of the mesa.

An outer peripheral surface of a part of the mesa other than the bottom portion need not intersect a stacking direction of the first and second structures.

An outer peripheral surface of a part of the mesa other than the bottom portion may intersect a stacking direction of the first and second structures.

At least an outer peripheral surface of the mesa may be covered with a protective film.

The protective film may be provided continuously along the convex portion on the outer peripheral surface of the bottom portion.

A peripheral region of the mesa of the first structure and at least a part of the protective film provided on the convex portion may be covered with a conductive film.

The conductive film may include conductive plating.

The convex portion may include a step that circles around the light-emitting region in plan view and/or an inclined portion that circles around the light-emitting region in plan view.

The convex portion may include a plurality of the steps.

The convex portion may include the inclined portion, and the inclined portion may be inclined in such a way as to be positioned outward in a width direction of the mesa as approaching a bottom surface of the mesa.

An inclination angle of the inclined portion with respect to a stacking direction of the first and second structures may be 10° or more.

The convex portion may include a plurality of the inclined portions.

The mesa may include another inclined portion in which an outer peripheral surface of a part other than the bottom portion circles around the light-emitting region in plan view and may be inclined in such a way as to be positioned outward in a width direction of the mesa as approaching a bottom surface of the mesa.

The convex portion may include the inclined portion, and an inclination angle of the inclined portion with respect to a stacking direction of the first and second structures may be larger than an inclination angle of the another inclined portion.

The convex portion may include the step and the inclined portion.

The first structure may include a substrate on a side of the first semiconductor structure opposite a light-emitting layer side, and the first semiconductor structure may include at least one semiconductor layer arranged between the substrate and the light-emitting layer, a contact layer arranged between the substrate and the at least one semiconductor layer, and an etching stop layer arranged between the at least one semiconductor layer and the contact layer.

The first structure and/or the second structure may be provided with a current confinement area that sets the light-emitting region.

At least one of the first and second semiconductor structures may include a semiconductor multilayer mirror.

The present technology also provides an electronic device including:
a surface-emitting element including:
a first structure including a first semiconductor structure;
a second structure stacked with the first structure and including a second semiconductor structure; and
a light-emitting layer arranged between the first and second structures and including a light-emitting region, in which
a mesa including at least a part of the first semiconductor structure, the light-emitting layer, and the second semiconductor structure and having a bottom portion in the at least a part is formed, and
an outer peripheral surface of the bottom portion has a convex portion that circles around the light-emitting region in plan view.

### BRIEF DESCRIPTION OF DRAWINGS

Fig. 1 is a cross-sectional view of a surface-emitting element according to Example 1 of an embodiment of the present technology.
Fig. 2 is a plan view of the surface-emitting element according to Example 1 of the embodiment of the present technology.
Fig. 3 is a flowchart illustrating an example of a method for manufacturing the surface-emitting element according to Example 1 of the embodiment of the present technology.
Figs. 4A and 4B are cross-sectional views of each step of the example of the method for manufacturing the surface-emitting element according to Example 1 of the embodiment of the present technology.
Figs. 5A and 5B are cross-sectional views of each step of the example of the method for manufacturing the surface-emitting element according to Example 1 of the embodiment of the present technology.
Figs. 6A and 6B are cross-sectional views of each step of the example of the method for manufacturing the surface-emitting element according to Example 1 of the embodiment of the present technology.
Figs. 7A and 7B are cross-sectional views of each step of the example of the method for manufacturing the surface-emitting element according to Example 1 of the embodiment of the present technology.
Figs. 8A and 8B are cross-sectional views of each step of the example of the method for manufacturing the surface-emitting element according to Example 1 of the embodiment of the present technology.
Figs. 9A and 9B are cross-sectional views of each step of an example of the method for manufacturing the surface-emitting element according to the Example 1 of the embodiment of the present technology.
Fig. 10 is a cross-sectional view of a surface-emitting element according to Example 2 of the embodiment of the present technology.
Fig. 11 is a plan view of the surface-emitting element according to Example 2 of the embodiment of the present technology.
Fig. 12 is a flowchart illustrating an example of a method for manufacturing the surface-emitting element according to Example 2 of the embodiment of the present technology.
Figs. 13A and 13B are cross-sectional views of each step of an example of the method for manufacturing the surface-emitting element according to the Example 2 of the embodiment of the present technology.
Figs. 14A and 14B are cross-sectional views of each step of an example of the method for manufacturing the surface-emitting element according to the Example 2 of the embodiment of the present technology.
Figs. 15A and 15B are cross-sectional views of each step of an example of the method for manufacturing the surface-emitting element according to the Example 2 of the embodiment of the present technology.
Figs. 16A and 16B are cross-sectional views of each step of an example of the method for manufacturing the surface-emitting element according to the Example 2 of the embodiment of the present technology.
Figs. 17A and 17B are cross-sectional views of each step of an example of the method for manufacturing the surface-emitting element according to the Example 2 of the embodiment of the present technology.
Fig. 18 is a cross-sectional view of each step of the example of the method for manufacturing the surface-emitting element according to Example 2 of the embodiment of the present technology.
Fig. 19 is a cross-sectional view of a surface-emitting element according to Example 3 of the embodiment of the present technology.
Fig. 20 is a plan view of the surface-emitting element according to Example 3 of the embodiment of the present technology.
Fig. 21 is a cross-sectional view of a surface-emitting element according to Example 4 of the embodiment of the present technology.
Fig. 22 is a plan view of the surface-emitting element according to Example 4 of the embodiment of the present technology.
Fig. 23 is a cross-sectional view of a surface-emitting element according to Example 5 of the embodiment of the present technology.
Fig. 24 is a cross-sectional view of a surface-emitting element according to Example 6 of the embodiment of the present technology.
Fig. 25 is a cross-sectional view of a surface-emitting element according to Example 7 of the embodiment of the present technology.
Fig. 26 is a cross-sectional view of a surface-emitting element according to Example 8 of the embodiment of the present technology.
Fig. 27 is a cross-sectional view of a surface-emitting element according to Example 9 of the embodiment of the present technology.
Fig. 28 is a cross-sectional view of a surface-emitting element according to Example 10 of the embodiment of the present technology.
Fig. 29 is a cross-sectional view of a surface-emitting element according to Example 11 of the embodiment of the present technology.
Fig. 30 is a cross-sectional view of a surface-emitting element according to Example 12 of the embodiment of the present technology.
Fig. 31 is a cross-sectional view of a surface-emitting element according to Example 13 of the embodiment of the present technology.
Fig. 32 is a cross-sectional view of a surface-emitting element according to Modification 1 of Example 1 of the embodiment of the present technology.
Fig. 33 is a cross-sectional view of a surface-emitting element according to Modification 2 of Example 1 of the embodiment of the present technology.
Fig. 34 is a cross-sectional view of a surface-emitting element according to Modification 3 of Example 1 of the embodiment of the present technology.
Fig. 35 is a cross-sectional view of a surface-emitting element according to Modification 4 of Example 1 of the embodiment of the present technology.
Fig. 36 is a diagram illustrating an application example of the surface-emitting element according to Example 1 of the embodiment of the present technology to a distance measuring apparatus.
Fig. 37 is a block diagram illustrating an example of a schematic configuration of a vehicle control system.
Fig. 38 is an explanatory diagram illustrating an example of installation positions of a distance measuring device.

### MODE FOR CARRYING OUT THE INVENTION

A preferred embodiment of the present technology will be described in detail hereinafter with reference to the accompanying drawings. Note that, in the present specification and drawings, components having substantially the same functional configurations will be denoted by the same reference numerals, and redundant description thereof is omitted. The embodiment that will be described hereinafter is a representative embodiment of the present technology, and the scope of the present technology is not to be narrowly interpreted according to this embodiment. Even in a case where it is described in the present specification that the surface-emitting element according to the present technology exhibits a plurality of effects, the surface-emitting element according to the present technology may exhibit at least one effect. The effects described in the present specification are merely examples and are not limiting, and other effects may also be produced.

Furthermore, description will be provided in the following order.
0. Introduction
1. Surface-Emitting Element According to Example 1 of Embodiment of Present Technology
2. Surface-Emitting Element According to Example 2 of Embodiment of Present Technology
3. Surface-Emitting Element According to Example 3 of Embodiment of Present Technology
4. Surface-Emitting Element According to Example 4 of Embodiment of Present Technology
5. Surface-Emitting Element According to Example 5 of Embodiment of Present Technology
6. Surface-Emitting Element According to Example 6 of Embodiment of Present Technology
7. Surface-Emitting Element According to Example 7 of Embodiment of Present Technology
8. Surface-Emitting Element According to Example 8 of Embodiment of Present Technology
9. Surface-Emitting Element According to Example 9 of Embodiment of Present Technology
10. Surface-Emitting Element According to Example 10 of Embodiment of Present Technology
11. Surface-Emitting Element According to Example 11 of Embodiment of Present Technology
12. Surface-Emitting Element According to Example 12 of Embodiment of Present Technology
13. Surface-Emitting Element According to Example 13 of Embodiment of Present Technology
14. Modification of Present Technology
15. Application Example for Electronic Device
16. Example in Which Surface-Emitting Element Is Employed in Distance Measuring Apparatus
17. Example in Which Distance Measuring Apparatus Is Mounted on Mobile Body

### <0. Introduction>

Incidentally, in a surface-emitting element (for example, a surface-emitting laser, a light-emitting diode, or the like), it is important to improve stress resistance of a mesa in order to ensure reliability. In the mesa, an outer peripheral surface of a bottom portion is a portion having especially low stress resistance, and how the stress resistance of this portion can be improved is a key to ensure reliability.

Among the conventional surface-emitting elements, there are surface-emitting elements in which a step is provided on an outer peripheral surface of a part of a mesa other than a bottom portion (for example, see Patent Document 1) and surface-emitting elements in which the entirety of an outer peripheral surface of a mesa is inclined with respect to an emission direction (for example, see Patent Document 2).

In the conventional surface-emitting elements, however, since the entirety of an outer peripheral surface of a bottom portion of a mesa is a vertical surface or a steeply inclined surface, there is a concern that a local stress is generated at the bottom portion of the mesa and cracks occur. The occurrence of cracks causes deterioration of electro-optical characteristics (for example, a light emission wavelength, a beam shape, or the like), and causes a chemical reaction due to intrusion of foreign matters such as moisture and dust. That is, the occurrence of cracks causes a decrease in reliability. In the conventional surface-emitting elements, there is thus room for improvement in improving stress resistance at a bottom portion of a mesa.

Therefore, as a result of intensive studies, the inventors have succeeded in improving the stress resistance of the bottom portion of the mesa by devising a shape of the outer peripheral surface of the bottom portion of the mesa. The inventors have developed a surface-emitting element according to the present technology as a surface-emitting element to which this new knowledge has been introduced.

Specifically, in the surface-emitting element according to the present technology, the outer peripheral surface of the bottom portion of the mesa has a circumferential convex portion. As a result, it is possible to suppress generation of a local stress at the bottom portion of the mesa and to suppress occurrence of cracks.

In addition, in the surface-emitting element according to the present technology, since the outer peripheral surface of the bottom portion of the mesa has the convex portion, biting of a protective film is improved in a case where the outer peripheral surface of the mesa is covered with the protective film, and peeling of the protective film can be suppressed. Furthermore, in a case where a conductive film is provided on the protective film, an overlapping property between the protective film and the conductive film is increased, and peeling of the conductive film can be suppressed.

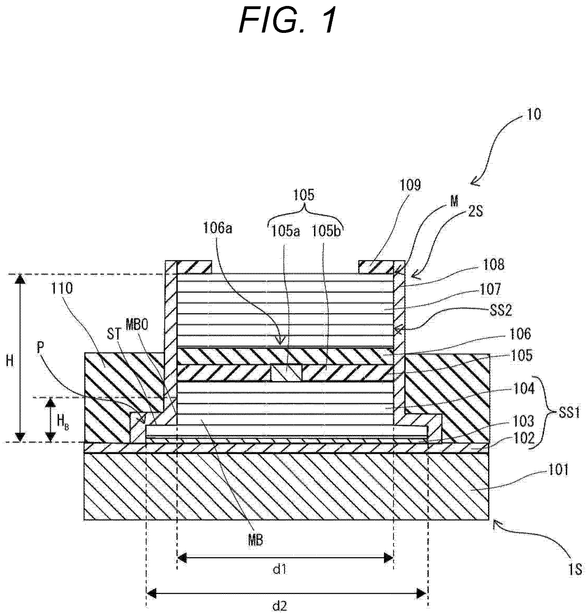

Some example of an embodiment of the surface-emitting element according to the present technology will be described in detail hereinafter. In cross-sectional views of Fig. 1 and other drawings, an upper side will be referred to as "upper" and a lower side will be referred to as "lower" as appropriate hereinafter.

### <1. Surface-Emitting Element According to Example 1 of Embodiment of Present Technology>

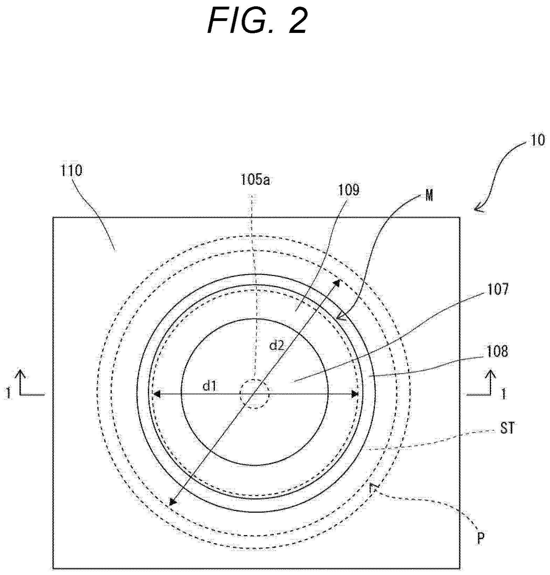

Fig. 1 is a cross-sectional view of a surface-emitting element 10 according to Example 1 of the embodiment of the present technology. Fig. 2 is a plan view of the surface-emitting element 10 according to Example 1 of the embodiment of the present technology. Fig. 1 is a cross-sectional view taken along line 1-1 in Fig. 2.

### <<Configuration of Surface-Emitting Element>>

### (Overall Configuration)

As an example, the surface-emitting element 10 according to the present technology is a vertical cavity surface-emitting laser (VCSEL). The surface-emitting element 10 is, for example, a VCSEL of a front surface emission type.

The surface-emitting element 10 is driven by a driver as an example. As an example, the driver includes a power supply and a transistor that controls on and off of energization from the power supply to the surface-emitting element 10.

As illustrated in Fig. 1 as an example, the surface-emitting element 10 has a first structure 1S including a first semiconductor structure SS1, a second structure 2S stacked with the first structure 1S and including a second semiconductor structure SS2, and a light-emitting layer 106 arranged between the first and second structures 1S and 2S and including a light-emitting region 106a. As an example, the first structure 1S further includes a substrate 101 disposed on a side of the first semiconductor structure SS1 opposite the light-emitting layer 106. The surface-emitting element 10 emits laser light to a side of the second structure 2S opposite a light-emitting layer 106 side (front surface side). A direction (vertical direction) in which the first and second structures 1S and 2S are stacked will also be referred to as a "stacking direction" hereinafter.

As an example, the first semiconductor structure SS1 includes a contact layer 102, an etching stop layer 103, and a first semiconductor multilayer mirror 104 in this order from a substrate 101 side.

As an example, an oxide confinement layer 105 including a current confinement region for setting a light-emitting region 106a is provided in the first structure 1S. Here, the oxide confinement layer 105 is arranged between the first semiconductor multilayer mirror 104 and the light-emitting layer 106.

As an example, the second semiconductor structure SS2 includes a second semiconductor multilayer mirror 107.

That is, in the surface-emitting element 10, as an example, the contact layer 102, the etching stop layer 103, the first semiconductor multilayer mirror 104, the oxide confinement layer 105, the light-emitting layer 106, and the second semiconductor multilayer mirror 107 are stacked on the substrate 101 in this order. In the surface-emitting element 10, a resonator is configured by including the light-emitting layer 106 and the first and second semiconductor multilayer mirrors 104 and 107 sandwiching the light-emitting layer 106 in a stacking direction. Note that a positional relationship between the oxide confinement layer 105 and the light-emitting layer 106 may be reversed.

A mesa M having a bottom portion MB in at least a part of the first semiconductor structure SS1 (for example, a portion including the etching stop layer 103 and the first semiconductor multilayer mirror 104) is configured by including at least the part of the first semiconductor structure SS1 (for example, the portion including the etching stop layer 103 and the first semiconductor multilayer mirror 104), the light-emitting layer 106, and the second semiconductor structure SS2 (for example, the second semiconductor multilayer mirror 107).

As an example, a cathode electrode 109 (n-side electrode) is provided at a top of the mesa M. The top of the mesa M is also called a "mesa top".

As an example, at least an outer peripheral surface of the mesa M is covered with an insulating film 108 as a protective film.

As an example, a peripheral region of the mesa M of the first structure 1S (a peripheral region of the mesa M on an upper surface of the contact layer 102) and at least a part (for example, a lower half) of the insulating film 108 are covered with a conductive film as an anode electrode 110 (p-side electrode).

That is, in the surface-emitting element 10, as an example, the anode electrode 110 and the cathode electrode 109 are arranged on the same surface side (front surface side) of the substrate 101.

### (Substrate)

As an example, the substrate 101 includes a GaAs substrate (for example, an i-GaAs substrate).

### (Contact Layer)

As an example, the contact layer 102 includes a p-GaAs layer doped with a p-type impurity at a high concentration. Examples of the p-type impurity (dopant) include Zn, Mg, Be, and C.

### (Etching Stop Layer)

As an example, the etching stop layer 103 includes a GaInP layer. Note that the etching stop layer 103 can be rephrased as any of a "layer", a "semiconductor layer", and a "compound semiconductor layer". Note that, as means for using materials having different etching rates, Ge, N, Se, or the like can be used in a case where a main group V material is As, and Ga, In, Zn, or the like can be used in a case where a main group III material is Al, or vice versa.

### (First Semiconductor Multilayer Mirror)

As an example, the first semiconductor multilayer mirror 104 is a semiconductor multilayer mirror doped with a p-type impurity, has little light absorption, and has high reflectance and conductivity. The semiconductor multilayer mirror has a structure in which a plurality of types (for example, two types) of semiconductor layers (for example, AlGaAs layers) having different refractive indices is alternately stacked with an optical thickness that is 1/4 of an emission wavelength. Examples of the p-type impurity (p-type dopant) include Zn, Mg, Be, and C.

### (Light-Emitting Layer)

As an example, the light-emitting layer 106 includes a compound semiconductor having band gap energy smaller than those of the first and second semiconductor structures SS1 and SS2. The light-emitting layer 106 includes, for example, a GaAs-based compound semiconductor (for example, GaAs, AlGaAs, GaInAs, GaInAsN, or the like). The light-emitting layer 106 may have a quantum well structure, a multiple quantum well structure, or a quantum dot structure. The light-emitting layer 106 is also called an "active layer". The light-emitting region 106a is a region (current injection region) into which a current is injected in the light-emitting layer 106 and is a region that emits light.

### (Oxide Confinement Layer)

The oxide confinement layer 105 has a non-oxidized region 105a, which is a region corresponding to the light-emitting region 106a, and an oxidized region 105b surrounding the non-oxidized region 105a. The non-oxidized region 105a includes a compound semiconductor (for example, AlGaAs, AlAs, or the like). The oxidized region 105b includes an oxide (for example, AlₓO_{y}). The non-oxidized region 105a functions as a current and light passage region, and the oxidized region 105b functions as a current and light confinement region.

### (Second Semiconductor Multilayer Mirror)

As an example, the second semiconductor multilayer mirror 107 is a semiconductor multilayer mirror doped with an n-type impurity, has little light absorption, and has high reflectance and conductivity. The semiconductor multilayer mirror has a structure in which a plurality of types (for example, two types) of semiconductor layers (for example, AlGaAs layers) having different refractive indices is alternately stacked with an optical thickness that is 1/4 of an emission wavelength. Examples of the n-type impurity (n-type dopant) include Si, Se, and Ge. The second semiconductor multilayer mirror 107 is set slightly lower in reflectance than the first semiconductor multilayer mirror 104.

In the surface-emitting element 10, the light-emitting layer 106 has a double heterostructure sandwiched, in the stacking direction, between the first and second semiconductor multilayer mirrors 104 and 107 having different conductivity types, and holes and electrons can undergo radiative recombination in the light-emitting layer 106.

### (Protective Film)

The insulating film 108 as the protective film includes a dielectric such as SiO₂, SiN, or SiON.

### (Cathode Electrode)

The cathode electrode 109 is a circumferential (for example, ring-shaped) electrode disposed in such a way as to surround the light-emitting region 106a in plan view. Examples thereof include Au/Ni/AuGe and Au/Pt/Ti. The cathode electrode is connected to a cathode side of the driver.

### (Anode Electrode)

The conductive film as the anode electrode 110 includes, for example, conductive plating. The conductive plating include, for example, Au, Ag, Cu, or the like. The anode electrode is connected to an anode side of the driver.

### (Mesa, Protective Film, and Conductive Film)

As an example, the mesa M has a height of several µm to ten or more of µm (for example, about 3 to 10 µm). Here, a planar shape of the mesa M is a circle (see Fig. 2), but may be a polygon such as an ellipse, a square, a rectangle, a hexagon, or an octagon, instead.

The mesa M has a convex portion P in which an outer peripheral surface MBO of the bottom portion MB circles around the light-emitting region 106a in plan view (see Figs. 1 and 2). As an example, the convex portion P includes a step ST that circles around the light-emitting region 106a in plan view (see Figs. 1 and 2). The bottom portion MB of the mesa M is also called a "mesa bottom". Note that the convex portion P need not necessarily be continuous over the entire circumference, and may have an intermittent portion (for example, a notch portion) or may be partially provided, instead. The convex portion P can be rephrased as a "protrusion".

A height H_{B} of the bottom portion MB is preferably, for example, 1/3 or less of a height H of the mesa M. The height H_{B} of the bottom portion MB may be, for example, 1/4 or less, 1/5 or less, or 1/6 or less of the height H of the mesa M. The height H_{B} of the bottom portion MB is preferably, for example, 1/10 or more of a height H of the mesa M. The height H_{B} of the bottom portion MB may be, for example, 1/9 or more, 1/8 or more, or 1/7 or more of the height H of the mesa M.

In the mesa M, an outer peripheral surface of a part other than the bottom portion MB (an upper part of the bottom portion) does not intersect the stacking direction (vertical direction, emission direction) of the first and second structures 1S and 2S. That is, the outer peripheral surface of the upper part of the bottom portion MB of the mesa M is essentially perpendicular to the substrate 101. In this case, the mesa M has a first diameter d1, which is a diameter of the upper part of the convex portion P, and a second diameter d2 (> d1), which is a diameter of the step ST of the convex portion P.

The insulating film 108 as the protective film covering the outer peripheral surface of the mesa M is continuously provided along the convex portion P on the outer peripheral surface MBO of the bottom portion MB. That is, the insulating film 108 is formed in close contact with the outer peripheral surface MBO of the bottom portion MB including the convex portion P without any gap.

The peripheral region of the mesa M of the first structure S1 (the peripheral region of the mesa M on the upper surface of the contact layer 102) and at least a part of the insulating film 108 as the protective film provided on the convex portion P is covered with the conductive film as the anode electrode 110. That is, the conductive film is formed on the contact layer 102 and the insulating film 108 in close contact with each other without any gap. A current applied from the driver through the anode electrode 110 flows in a lateral direction through the contact layer 102 and flows into the mesa M from a bottom surface side.

### <<Operation of Surface-Emitting Element>>

The operation of the surface-emitting element 10 will be described hereinafter. When the power supply voltage of the driver is applied to the surface-emitting element 10, a current from the anode side of the driver is confined by the oxide confinement layer 105 and injected into the light-emitting region 106a of the light-emitting layer 106 after flowing through the anode electrode 110, the contact layer 102, the etching stop layer 103, and the first semiconductor multilayer mirror 104 in this order. At this time, the light-emitting region 106a emits light, and the light travels between the first and second semiconductor multilayer mirrors 104 and 107 while being confined by the oxide confinement layer 105 and amplified by the light-emitting layer 106, and is emitted as laser light from the upper side of the first semiconductor multilayer mirror 107 when an oscillation condition is satisfied. The current injected into the light-emitting region 106a flows out to the cathode side of the driver after flowing through the second semiconductor multilayer mirror 107 and the cathode electrode 109 in this order.

### <<Method for Manufacturing Surface-Emitting Element>>

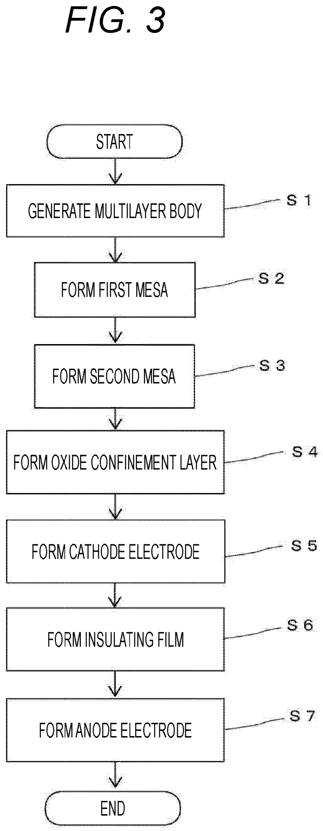

An example of a method for manufacturing the surface-emitting element 10 will be described hereinafter with reference to a flowchart of Fig. 3 and the like. As an overall flow, first, a plurality of surface-emitting elements 10 is simultaneously generated on one wafer (hereinafter referred to as a "substrate 101" for convenience), which is a base material of the substrate 101, by a semiconductor manufacturing method using a semiconductor manufacturing apparatus. Next, the plurality of continuous integrated surface-emitting elements 10 is separated from each other by dicing to obtain chip-shaped surface-emitting elements 10.

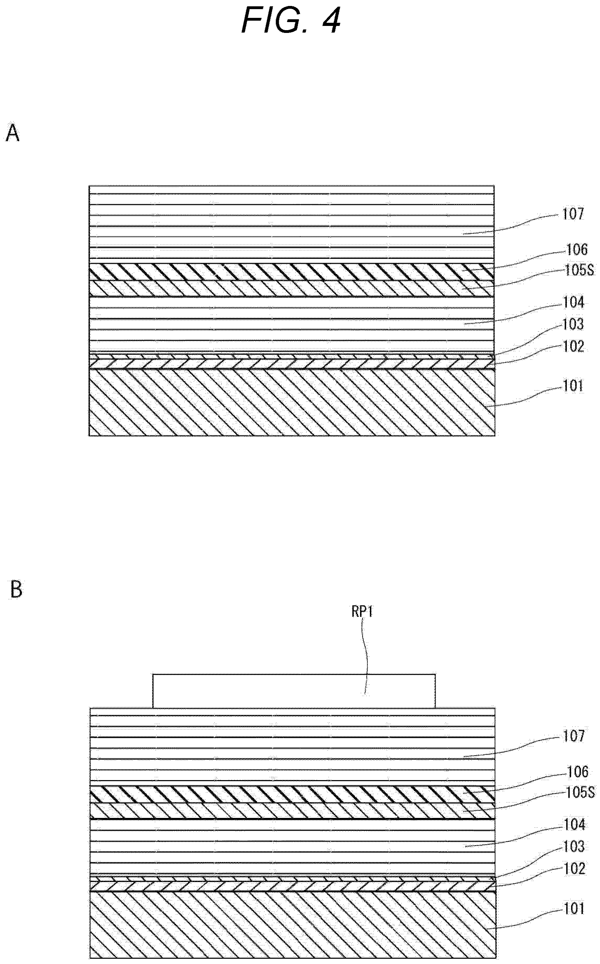

In the first step S1, a multilayer body is generated (see Fig. 4A). Specifically, for example, the contact layer 102, the etching stop layer 103, the first semiconductor multilayer mirror 104, an oxidation layer 105S (for example, an AlGaAs layer, an AlAs layer, or the like), the light-emitting layer 106, and the second semiconductor multilayer mirror 107 are stacked in this order on the substrate 101 as a growth substrate by an epitaxial crystal growth method such as a metal organic chemical vapor deposition (MOCVD) method to generate a multilayer body. At this time, as raw materials of the compound semiconductor, for example, a methyl-based organometallic gas such as trimethylaluminum (TMAl), trimethylgallium (TMGa), or trimethylindium (TMIn) and an arsine (AsH₃) gas are used, as a raw material of donor impurities, for example, disilane (Si₂H₆) is used, and as a raw material of acceptor impurities, for example, carbon tetrabromide (CBr₄) is used.

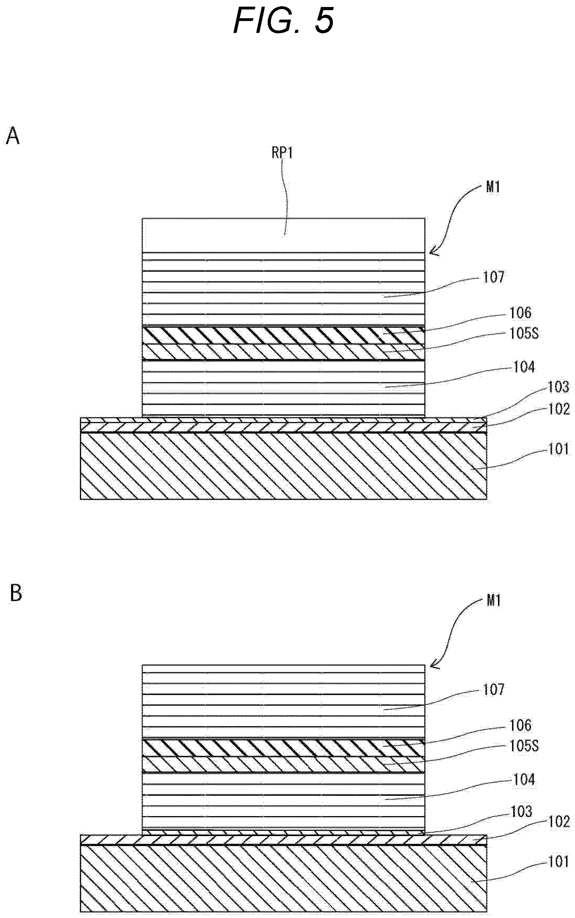

In the next step S2, a first mesa M1 is formed. Specifically, a resist pattern RP1 (see Fig. 4B) covering a portion where the first mesa M1 is to be formed is formed on the multilayer body by photolithography, and the multilayer body is etched by dry etching or wet etching using the resist pattern RP1 as a mask. The etching is stopped when the etching stop layer 103 is exposed. As a result, the first mesa M1 is formed (see Fig. 5A). Thereafter, a part of the unnecessary etching stop layer 103 around first mesa M1 is removed to expose the contact layer 102 around first mesa M1, and the resist pattern RP1 is removed to expose a top of first mesa M1 (see Fig. 5B).

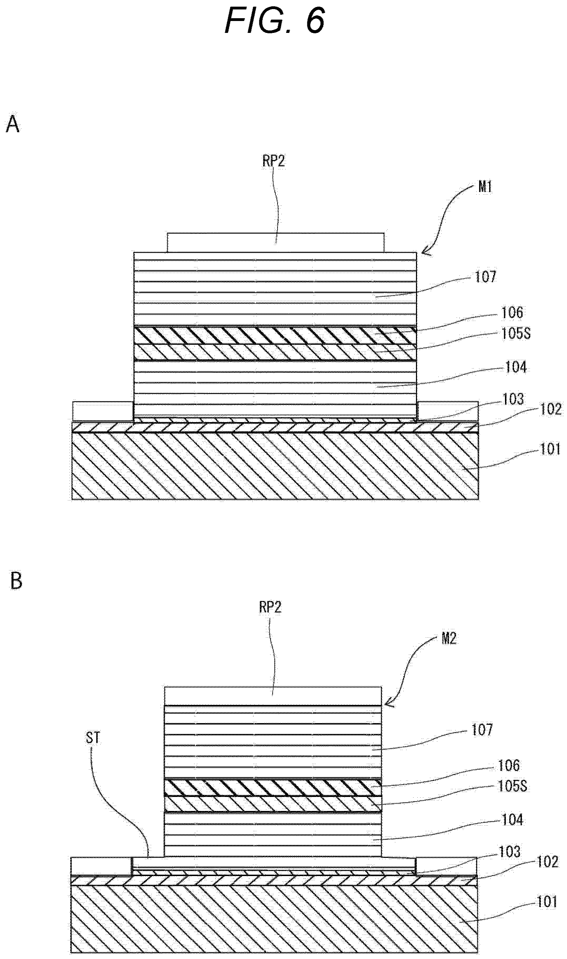

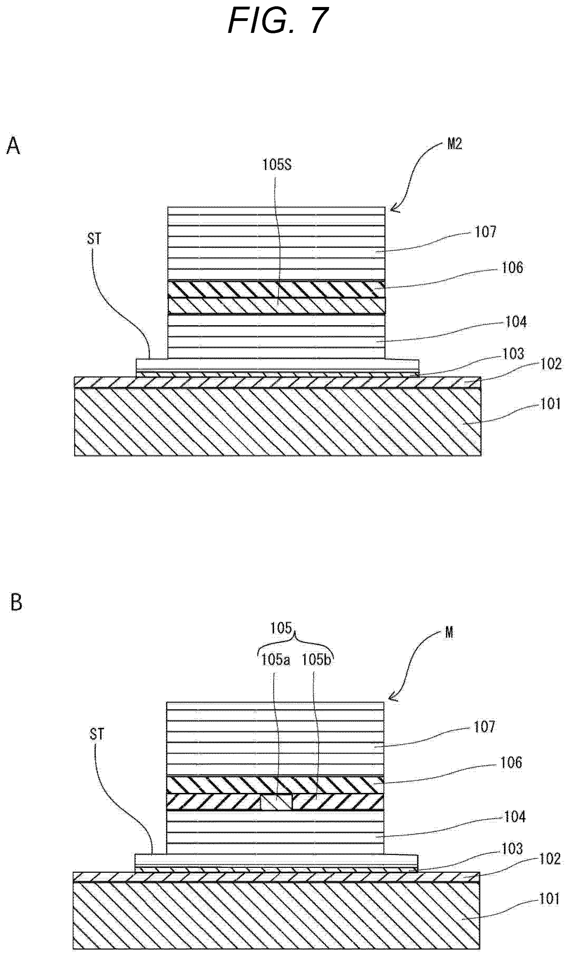

In the next step S3, a second mesa M2 is formed. Specifically, a resist pattern RP2 having an opening for forming the second mesa M2 is formed on the first mesa M1 by photolithography (see Fig. 6A), and the first mesa M1 is etched by dry etching or wet etching using the resist pattern RP2 as a mask. The etching is performed here as deeply as an upper surface of the bottom portion of the first mesa M1 (an upper surface of a lower part of the first semiconductor multilayer mirror 104) is exposed. As a result, a second mesa M2 having the circumferential step ST on the outer peripheral surface is formed (see Fig. 6B). Thereafter, the resist pattern RP2 is removed (see Fig. 7A).

In the next step S4, the oxide confinement layer 105 is formed (see Fig. 7B). Specifically, the second mesa M2 (see Fig. 7A) is exposed to a high-temperature water vapor atmosphere, and the oxidation layer 105S is selectively oxidized by a predetermined distance from a side surface. As a result, the oxide confinement layer 105 in which the non-oxidized region 105a is surrounded by the oxidized region 105b is formed, and the second mesa M2 becomes the mesa M.

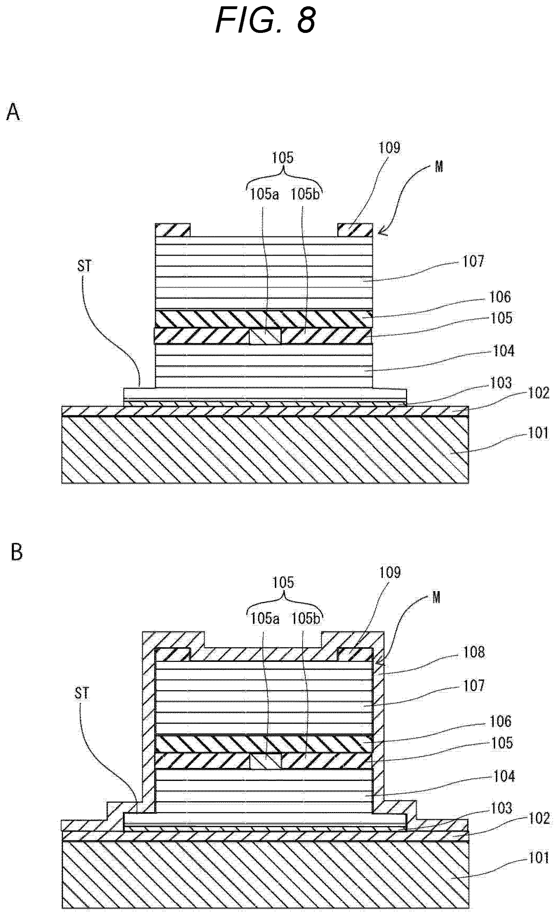

In the next step S5, the cathode electrode 109 is formed (see Fig. 8A). Specifically, for example, the cathode electrode 109 is formed in a circumferential shape (for example, a ring shape) on the top of the mesa M by a lift-off method. At this time, for example, vapor deposition, sputtering, or the like is used to form the electrode material.

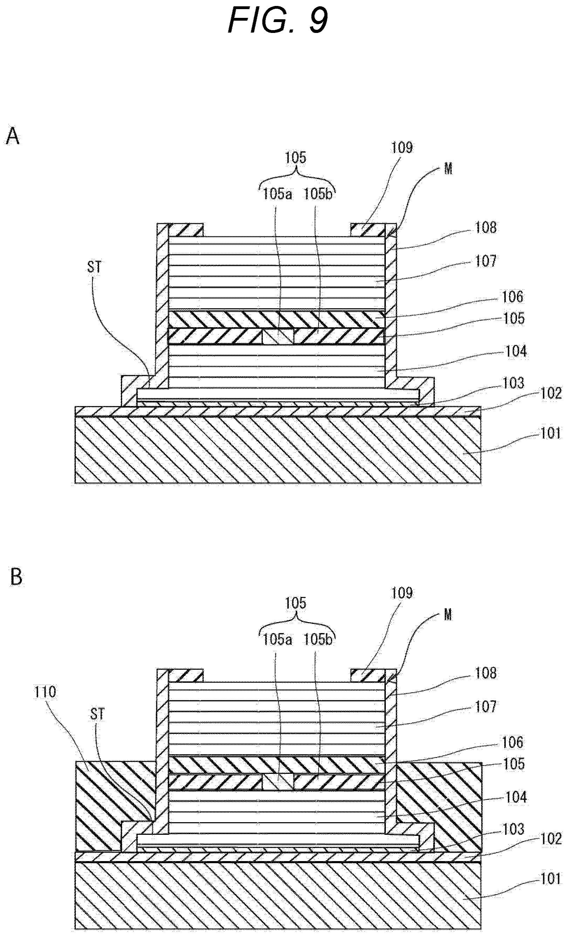

In the next step S6, the insulating film 108 is formed. Specifically, first, the insulating film 108 is formed on the entire surface (see Fig. 8B). At this time, the insulating film 108 is also formed along the step ST at the mesa bottom without any gap. Next, a part of the insulating film 108 is removed by photolithography and etching to expose the peripheral region of the mesa M of the contact layer 102, the cathode electrode 109, and the top of the mesa M (see Fig. 9A).

In the final step S7, the anode electrode 110 is formed (see Fig. 9B). Specifically, for example, a conductive film (for example, conductive plating) as the anode electrode 110 is formed by a plating method in such a way as to cover the insulating film 108 formed on the outer peripheral surface of the peripheral region of the mesa M on the contact layer 102 and the portion (for example, the lower half) including the bottom portion of the mesa M. At this time, the conductive film is also formed without any gap with respect to the insulating film 108 formed along the step ST at the mesa bottom. Note that it is preferable to form a seed layer in advance at a position where conductive plating is to be formed.

### <<Effects of Surface-Emitting Element and Method for Manufacturing Surface-Emitting Element>>

Effects of the surface-emitting element 10 and the method for manufacturing the surface-emitting element 10 will be described hereinafter.

The surface-emitting element 10 has a first structure 1S including a first semiconductor structure SS1, a second structure 2S stacked with the first structure and including a second semiconductor structure SS2, and a light-emitting layer 106 arranged between the first and second structures 1S and 2S and including a light-emitting region 106a. A mesa M having a bottom portion MB is configured in at least a part of the first semiconductor structure SS1 (for example, the etching stop layer 103 and the first semiconductor multilayer mirror 104) by including the at least a part, the light-emitting layer 106, and the second semiconductor structure SS2 (for example, the second semiconductor multilayer mirror 107). The outer peripheral surface MBO of the bottom portion MB has a convex portion P that circles around the light-emitting region 106a in plan view.

In this case, as compared with a case where the outer peripheral surface MBO of the bottom portion MB does not have the convex portion P, stress generated in the bottom portion MB can be alleviated (dispersed) (generation of a local stress can be suppressed).

As a result, with the surface-emitting element 10, it is possible to provide a surface-emitting element capable of improving the stress resistance of the bottom portion of the mesa. Since the stress resistance of the bottom portion MB of the mesa can be improved, the occurrence of cracks in the bottom portion MB can be suppressed. As a result, it is possible to suppress variations in electro-optical characteristics (light emission wavelength and beam shape), and it is possible to suppress chemical reactions due to intrusion of foreign matters such as moisture and dust. Consequently, reliability can be improved.

At least the outer peripheral surface of the mesa M is covered with the insulating film 108 as the protective film. As a result, at least the mesa M can be protected, and the reliability can be improved.

The insulating film 108 as the protective film is continuously provided along the convex portion P on the outer peripheral surface MBO of the bottom portion MB. As a result, the insulating film 108 and the outer peripheral surface MBO can be brought into close contact with each other without any gap, peeling of the insulating film 108 can be suppressed, and entry of foreign matters such as moisture and dust can be prevented. As a result, the reliability can be further improved.

Note that in a case where no convex portion is provided on the outer peripheral surface of the mesa bottom, stress is likely to concentrate particularly at a boundary between the mesa bottom and a peripheral region (local stress is likely to occur), and there is a concern that cracks are likely to occur and the protective film is likely to peel off.

The peripheral region of the mesa M of the first structure 1S (the peripheral region of the mesa M on the contact layer 102) and at least the part of the insulating film 108 provided on the convex portion P are covered with the conductive film as the anode electrode 110. As a result, the anode electrode 110 and the contact layer 102 can be made conductive, and the anode electrode 110 and the insulating film 108 can be brought into close contact with each other without any gap, and peeling of the anode electrode 110 can be suppressed. Furthermore, since there is no gap between the insulating film 108 and the outer peripheral surface MBO of the mesa bottom, insulation between the anode electrode 110 and the outer peripheral surface MBO can be reliably secured.

The conductive film as the anode electrode 110 includes conductive plating. Conductivity of the conductive film can thus be improved.

The method for manufacturing the surface-emitting element 10 includes a step of stacking the first semiconductor structure SS1, the light-emitting layer 106, and the second semiconductor structure SS2 on the substrate 101 in this order to generate a multilayer body, a step of etching the multilayer body to form the first mesa M1, and a step of etching the first mesa M1 to form the second mesa M2 including at least a part (for example, the step ST) of the convex portion P circling around the outer peripheral surface of the bottom portion.

With the method for manufacturing the surface-emitting element 10, the surface-emitting element 10 can be manufactured easily (with a small number of steps) using a semiconductor manufacturing method.

In the step of generating the multilayer body, the contact layer 102, the etching stop layer 103, and the first semiconductor multilayer mirror 104 included in the first semiconductor structure SS1 are stacked on the substrate 101 in this order. As a result, the first mesa M1 can be formed without etching the contact layer 102.

The method for manufacturing the surface-emitting element 10 further includes a step of covering the outer peripheral surface of the second mesa M2 with the insulating film 108 as the protective film. As a result, the insulating film 108 can be formed in close contact with the outer peripheral surface of the second mesa M2 having the convex portion P without any gap.

The method for manufacturing the surface-emitting element 10 further includes a step of covering the insulating film 108 as the protective film and the peripheral region of the mesa M (the peripheral region of the mesa M of the contact layer 102) with the conductive film as the anode electrode 110. As a result, the anode electrode 110 and the contact layer 102 can be made conductive with each other, and the anode electrode 110 and the insulating film 108 can be brought into close contact with each other without any gap.

### <2. Surface-Emitting Element According to Example 2 of Embodiment of Present Technology>

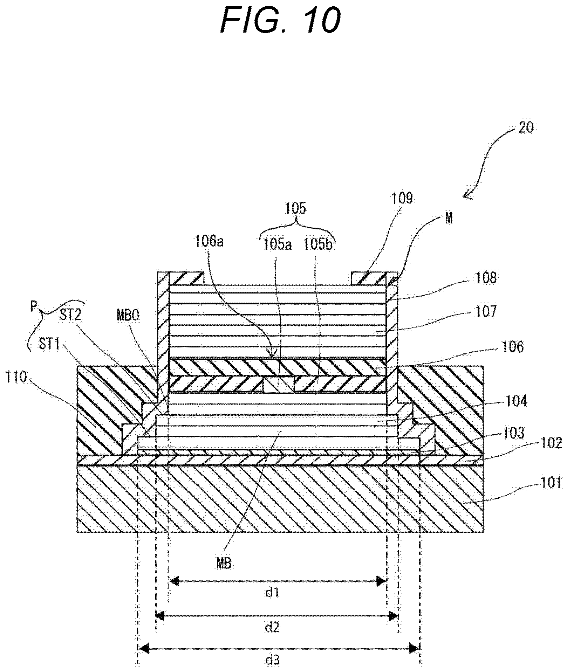

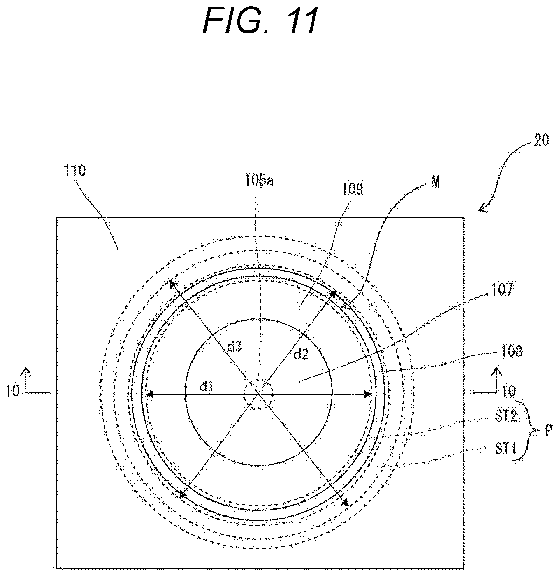

Fig. 10 is a cross-sectional view of a surface-emitting element 20 according to Example 2 of the embodiment of the present technology. Fig. 11 is a plan view of the surface-emitting element 20 according to Example 2 of the embodiment of the present technology. Fig. 10 is a cross-sectional view taken along line 10-10 in Fig. 11.

### <<Configuration of Surface-Emitting Element>>

As illustrated in Figs. 10 and 11, the surface-emitting element 20 has a configuration generally similar to that of the surface-emitting element 10 according to Example 1 except that the convex portion P has a plurality of steps (for example, first and second steps ST1 and ST2) that circles around the light-emitting region 106a.

The first and second steps ST1 and ST2 have different positions in a height direction and a width direction of the mesa M. More specifically, the first step ST1 is located at a lower position than (below) the second step ST1 in the height direction of the mesa M, and the first step ST1 is located outside the second step ST2 in the width direction (for example, radial direction) of the mesa M. That is, the closer the first and second steps ST1 and ST2 are to the bottom surface of the mesa M (for example, the first step ST1), the more outward in the width direction of the mesa M.

In the surface-emitting element 20, the mesa M has a first diameter d1, which is a diameter of an upper part of the convex portion P, a second diameter d2 (> d1), which is a diameter of the second step ST2 of the convex portion P, and a third diameter d3 (> d2), which is a diameter of the first step ST1 of the convex portion P.

### <<Operation of Surface-Emitting Element>>

The surface-emitting element 20 performs an operation similar to that of the surface-emitting element 10.

### <<Method for Manufacturing Surface-Emitting Element>>

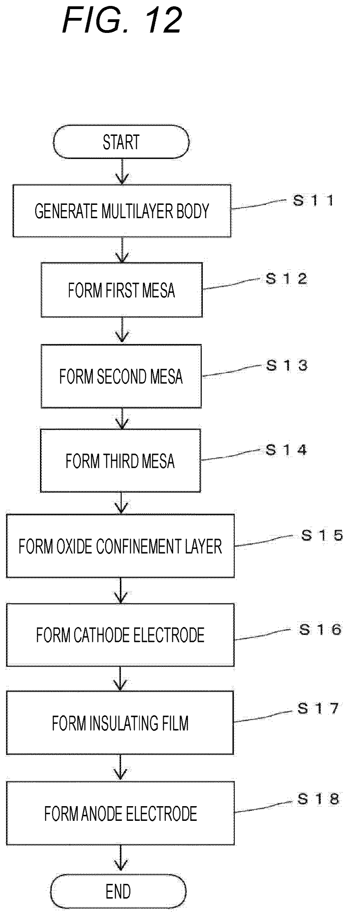

An example of a method for manufacturing the surface-emitting element 20 will be described hereinafter with reference to a flowchart of Fig. 12 and the like. As an overall flow, first, a plurality of surface-emitting elements 20 is simultaneously generated on one wafer (hereinafter referred to as a "substrate 101" for convenience), which is a base material of the substrate 101, by a semiconductor manufacturing method using a semiconductor manufacturing apparatus. Next, the plurality of continuous integrated surface-emitting elements 20 is separated from each other by dicing to obtain chip-shaped surface-emitting elements 20.

In the first step S11, a multilayer body is generated (see Fig. 4A). Specifically, for example, the contact layer 102, the etching stop layer 103, the first semiconductor multilayer mirror 104, an oxidation layer 105S (for example, an AlGaAs layer, an AlAs layer, or the like), the light-emitting layer 106, and the second semiconductor multilayer mirror 107 are stacked in this order on the substrate 101 as a growth substrate by an epitaxial crystal growth method such as a metal organic chemical vapor deposition (MOCVD) method to generate a multilayer body. At this time, as raw materials of the compound semiconductor, for example, a methyl-based organometallic gas such as trimethylaluminum (TMAl), trimethylgallium (TMGa), or trimethylindium (TMIn) and an arsine (AsH₃) gas are used, as a raw material of donor impurities, for example, disilane (Si₂H₆) is used, and as a raw material of acceptor impurities, for example, carbon tetrabromide (CBr₄) is used.

In the next step S12, the first mesa M1 is formed. Specifically, a resist pattern RP1 (see Fig. 4B) covering a portion where the first mesa M1 is to be formed is formed on the multilayer body by photolithography, and the multilayer body is etched by dry etching or wet etching using the resist pattern RP1 as a mask. The etching is stopped when the etching stop layer 103 is exposed. As a result, the first mesa M1 is formed (see Fig. 5A). Thereafter, a part of the unnecessary etching stop layer 103 around first mesa M1 is removed to expose the contact layer 102 around first mesa M1, and the resist pattern RP1 is removed to expose a top of first mesa M1 (see Fig. 5B).

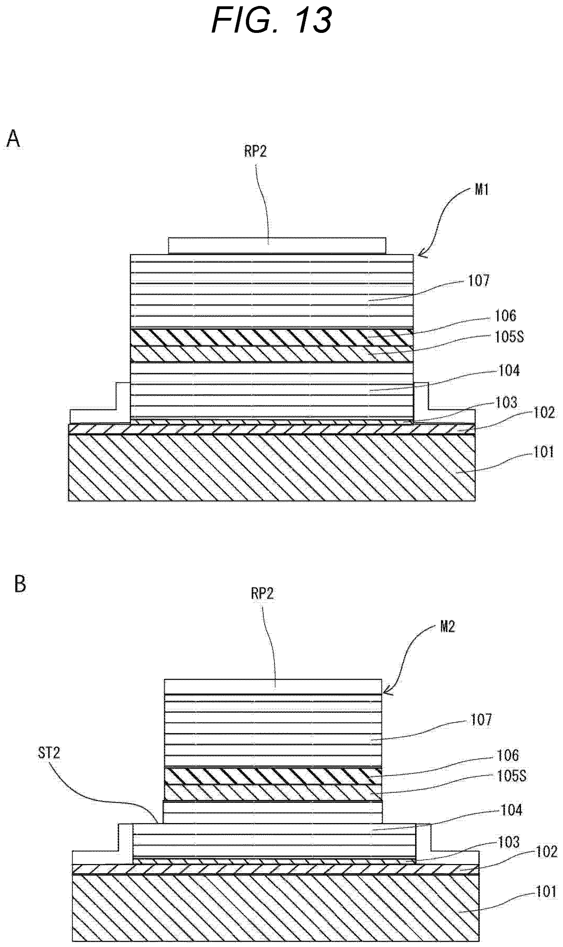

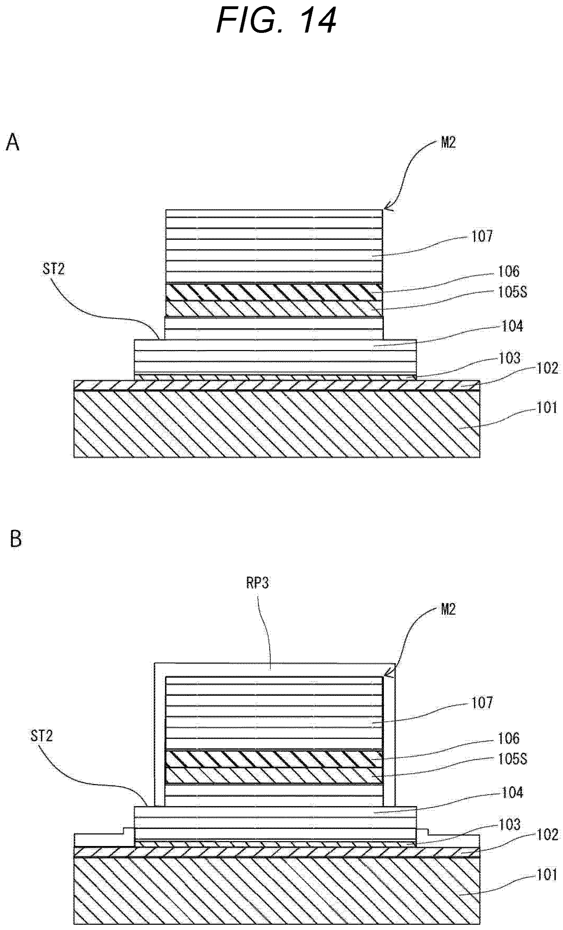

In the next step S13, the second mesa M2 is formed. Specifically, a resist pattern RP2 having an opening for forming the second mesa M2 is formed on the first mesa M1 by photolithography (see Fig. 13A), and the first mesa M1 is etched by dry etching or wet etching using the resist pattern RP2 as a mask. The etching is performed here as deeply as an upper surface of the bottom portion of the first mesa M (an upper surface of a middle portion of the first semiconductor multilayer mirror 104) is exposed. As a result, the second mesa M2 having the second step ST2 on the outer peripheral surface is formed (see Fig. 13B). Thereafter, the resist pattern RP2 is removed (see Fig. 14A).

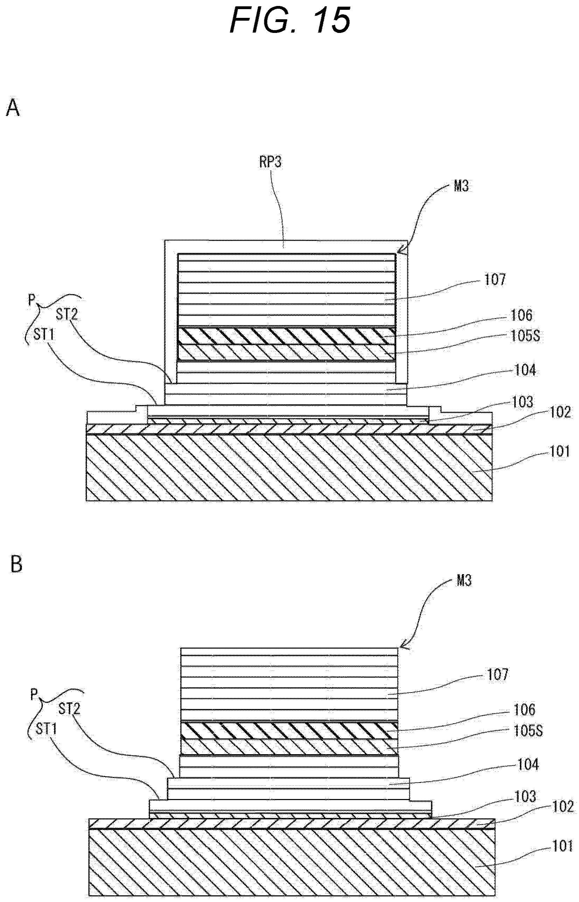

In the next step S14, a third mesa M3 is formed. Specifically, a resist pattern RP3 having an opening for forming the third mesa M3 is formed on the second mesa M2 by photolithography (see Fig. 14B), and the second mesa M2 is etched by dry etching or wet etching using the resist pattern RP3 as a mask. The etching is performed here as deeply as an upper surface of the bottom portion of the second mesa M2 (the upper surface of the lower portion of the first semiconductor multilayer mirror 104) is exposed. As a result, the third mesa M3 having the convex portion P including the first and second steps ST1 and ST2 on the outer peripheral surface is formed (see Fig. 15A). Thereafter, the resist pattern RP3 is removed (see Fig. 15B).

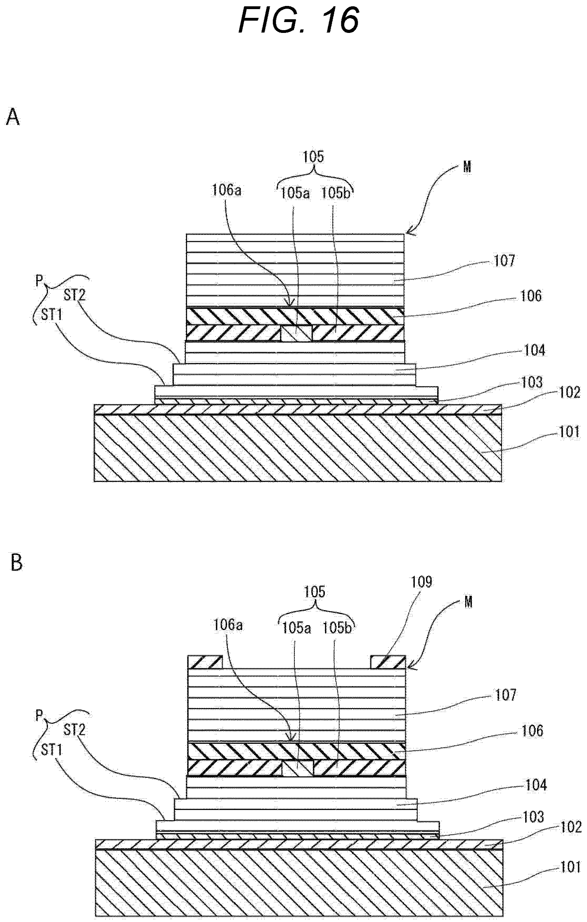

In the next step S15, the oxide confinement layer 105 is formed (see Fig. 16A). Specifically, the third mesa M3 (see Fig. 15B) is exposed to a high-temperature water vapor atmosphere, and the oxidation layer 105S is selectively oxidized by a predetermined distance from a side surface. As a result, the oxide confinement layer 105 in which the non-oxidized region 105a is surrounded by the oxidized region 105b is formed, and the third mesa M3 becomes the mesa M.

In the next step S16, the cathode electrode 109 is formed (see Fig. 16B). Specifically, for example, the cathode electrode 109 is formed in a circumferential shape (for example, a ring shape) on the top of the mesa M by a lift-off method. At this time, for example, vapor deposition, sputtering, or the like is used to form the electrode material.

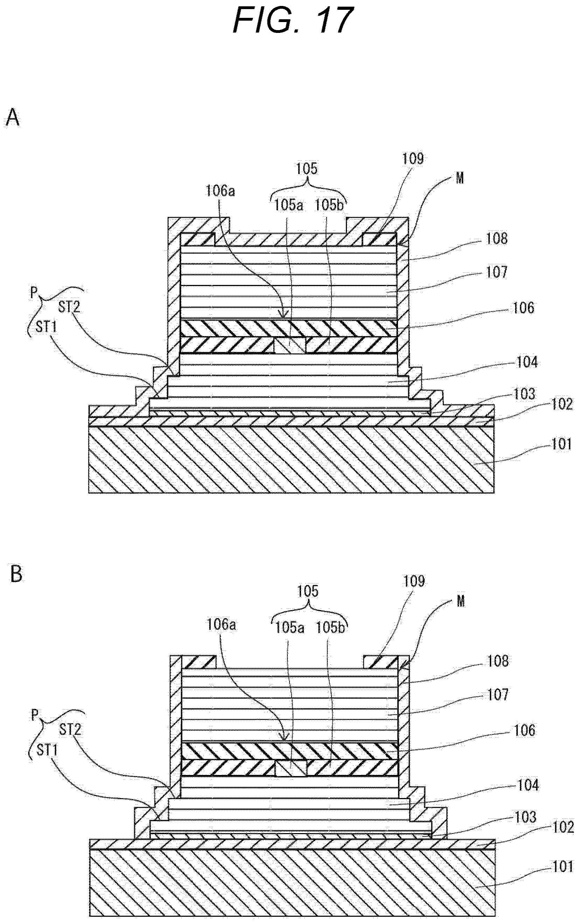

In the next step S17, the insulating film 108 is formed. Specifically, first, the insulating film 108 is formed on the entire surface (see Fig. 17A). At this time, the insulating film 108 is also formed along the first and second steps ST1 and ST2 at the mesa bottom without any gap. Next, a part of the insulating film 108 is removed by photolithography and etching to expose the peripheral region of the mesa M of the contact layer 102, the cathode electrode 109, and the top of the mesa M (see Fig. 17B).

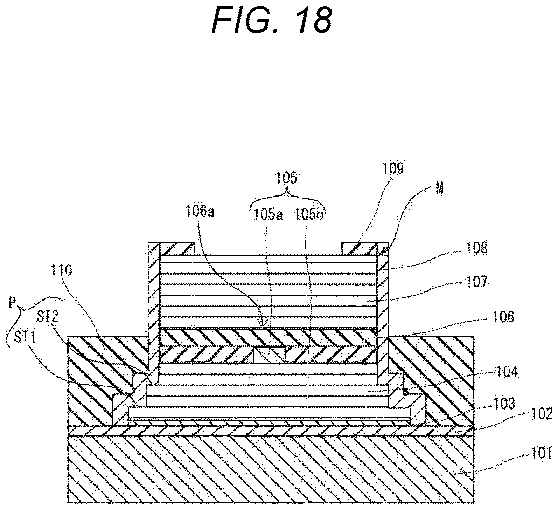

In the final step S18, the anode electrode 110 is formed (see Fig. 18). Specifically, for example, a conductive film (for example, conductive plating) as the anode electrode 110 is formed by a plating method in such a way as to cover the insulating film 108 formed on the outer peripheral surface of the peripheral region of the mesa M on the contact layer 102 and the portion (for example, the lower half) including the bottom portion of the mesa M. At this time, the conductive film is also formed without any gap with respect to the insulating film 108 formed along the first and second steps ST1 and ST2 at the mesa bottom. Note that it is preferable to form a seed layer in advance at a position where conductive plating is to be formed.

### <<Effects of Surface-Emitting Element and Method for Manufacturing Surface-Emitting Element>>

With the surface-emitting element 20, since the convex portion P has the first and second steps ST1 and ST2 circling around the light-emitting region 106a, a stress generated in the bottom portion MB can be further alleviated (dispersed). As a result, with the surface-emitting element 20, it is possible to provide a surface-emitting element with a higher stress resistance of the bottom portion MB of the mesa M.

The method for manufacturing the surface-emitting element 20 includes a step of stacking the first semiconductor structure SS1, the light-emitting layer 106, and the second semiconductor structure SS2 on the substrate 101 in this order to generate a multilayer body, a step of etching the multilayer body to form the first mesa M1, a step of etching the first mesa M1 to form the second mesa M2 including a part (the second step ST2) of the convex portion P circling around the outer peripheral surface of the bottom portion, and a step of etching the second mesa M2 to form the third mesa M3 including the convex portion P including the first and second steps ST1 and ST2 circling around the outer peripheral surface of the bottom portion.

With the method for manufacturing the surface-emitting element 20, the surface-emitting element 10 can be manufactured easily (with a small number of steps) using a semiconductor manufacturing method.

In the step of generating the multilayer body, the contact layer 102, the etching stop layer 103, and the first semiconductor multilayer mirror 104 included in the first semiconductor structure SS1 are stacked on the substrate 101 in this order. As a result, the first mesa M1 can be formed without etching the contact layer 102.

The method for manufacturing the surface-emitting element 20 further includes a step of covering an outer peripheral surface of the third mesa M3 with the insulating film 108 as the protective film. As a result, the insulating film 108 can be formed in close contact with the outer peripheral surface of the third mesa M3 having the convex portion P without any gap.

The method for manufacturing the surface-emitting element 20 further includes a step of covering the insulating film 108 as the protective film and the peripheral region of the mesa M (the peripheral region of the mesa M of the contact layer 102) with the conductive film as the anode electrode 110. As a result, the anode electrode 110 and the contact layer 102 can be made conductive with each other, and the anode electrode 110 and the insulating film 108 can be brought into close contact with each other without any gap.

### <3. Surface-Emitting Element According to Example 3 of Embodiment of Present Technology>

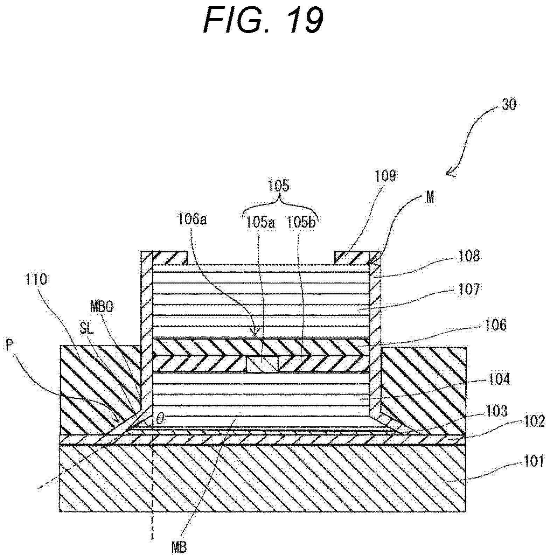

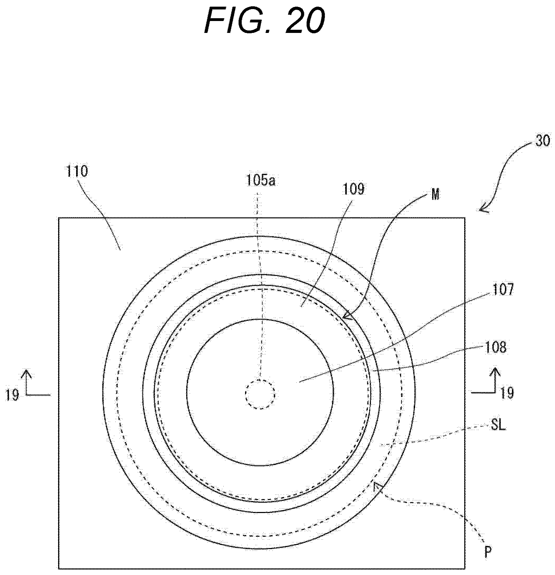

Fig. 19 is a cross-sectional view of a surface-emitting element 30 according to Example 3 of the embodiment of the present technology. Fig. 20 is a plan view of the surface-emitting element 30 according to Example 3 of the embodiment of the present technology. Fig. 19 is a cross-sectional view taken along line 19-19 in Fig. 20.

As illustrated in Figs. 19 and 20, the surface-emitting element 30 has a configuration generally similar to that of the surface-emitting element 10 according to Example 1 except that the convex portion P included in the outer peripheral surface MBO of the bottom portion MB of the mesa M has an inclined portion SL circling around the light-emitting region 106a.

The inclined portion SL is inclined in such a way as to be positioned more outward in the width direction of the mesa M as approaching the bottom surface of the mesa M.

An inclination angle θ of the inclined portion SL with respect to the stacking direction is, for example, preferably 10° or more, more preferably 20° or more, more preferably 30° or more, more preferably 40° or more, and most preferably 45°. The inclination angle θ is preferably 80° or less, more preferably 70° or less, more preferably 60° or less, more preferably 50° or less, and most preferably 45°. Note that the inclination angle θ is not limited to constant, and may change gradually or stepwise, or may be essentially arc-shaped, instead.

The surface-emitting element 30 performs an operation similar to that of the surface-emitting element 10 according to Example 1.

The surface-emitting element 30 can be manufactured by a manufacturing method generally similar to the method for manufacturing the surface-emitting element 10 according to Example 1 except that the inclined portion SL is formed by controlling an etching rate according to the progress of etching or by oblique etching.

With the surface-emitting element 30, effects generally similar to those of the surface-emitting element 10 according to Example 1 can be obtained.

### <4. Surface-Emitting Element According to Example 4 of Embodiment of Present Technology>

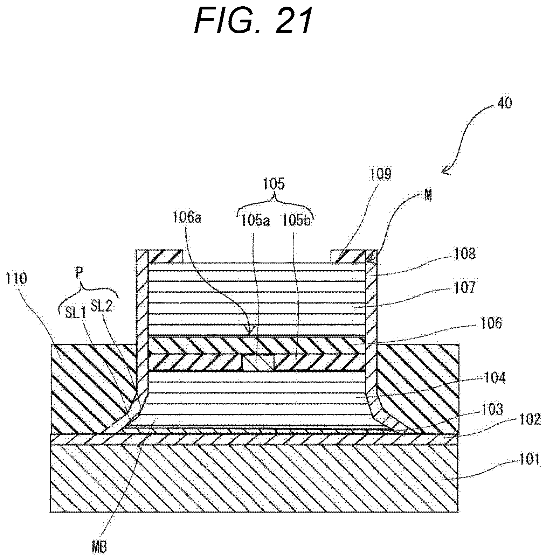

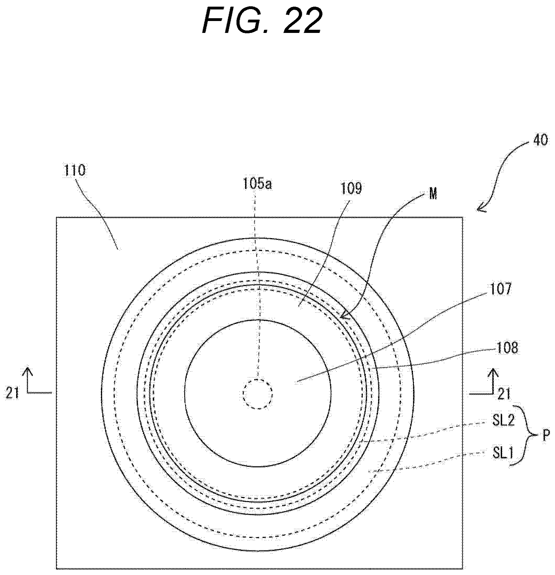

Fig. 21 is a cross-sectional view of a surface-emitting element 40 according to Example 4 of the embodiment of the present technology. Fig. 22 is a plan view of the surface-emitting element 40 according to Example 4 of the embodiment of the present technology. Fig. 21 is a cross-sectional view taken along line 21-21 in Fig. 22.

As illustrated in Figs. 21 and 22, the surface-emitting element 40 has a configuration generally similar to that of the surface-emitting element 10 according to Example 1 except that the convex portion P included in the outer peripheral surface MBO of the bottom portion MB of the mesa M has a plurality of inclined portions (for example, first and second inclined portions SL1 and SL2) circling around the light-emitting region 106a.

Each of the first and second inclined portions SL1 and SL2 is inclined in such a way as to be positioned more outward in the width direction of the mesa M as approaching the bottom surface of the mesa M.

The first and second inclined portions SL1 and SL2 have different positions in the height direction and the width direction of the mesa M. More specifically, the first inclined portion SL1 is located at a lower position than (below) the second inclined portion SL2 in the height direction of the mesa M, and the first inclined portion SL1 is located outside the second inclined portion SL2 in the width direction (for example, radial direction) of the mesa M. That is, the closer the first and second inclined portions SL1 and SL2 are to the bottom surface of the mesa M (for example, the first inclined portion SL1), the more outward in the width direction of the mesa M.

Here, the inclination angle of the first inclined portion SL1 with respect to the stacking direction is set to be larger than the inclination angle of the second inclined portion SL2 with respect to the stacking direction, but a magnitude relationship between both the inclination angles may be reversed.

The inclination angle of the first inclined portion SL1 with respect to the stacking direction is, for example, preferably 10° or more, more preferably 20° or more, more preferably 30° or more, more preferably 40° or more, and most preferably 45°. The inclination angle θ is preferably 80° or less, more preferably 70° or less, more preferably 60° or less, more preferably 50° or less, and most preferably 45°. The inclination angle of the second inclined portion SL2 with respect to the stacking direction is, for example, preferably 10° or more, more preferably 20° or more, more preferably 30° or more, more preferably 40° or more, and most preferably 45°. The inclination angle θ is preferably 80° or less, more preferably 70° or less, more preferably 60° or less, more preferably 50° or less, and most preferably 45°. Note that at least one of the inclination angle of the first inclined portion SL1 with respect to the stacking direction and the inclination angle of the second inclined portion SL2 with respect to the stacking direction is not limited to be constant, and may change gradually or stepwise, and may be essentially arc-shaped, instead.

The surface-emitting element 40 performs an operation similar to that of the surface-emitting element 10 according to Example 1.

The surface-emitting element 40 can be manufactured by a manufacturing method generally similar to the method for manufacturing the surface-emitting element 20 according to Example 2 except that the first and second inclined portions SL1 and SL2 are formed by controlling the etching rate according to the progress of etching or by oblique etching.

With the surface-emitting element 40, effects generally similar to those of the surface-emitting element 20 according to Example 2 can be obtained.

### <5. Surface-Emitting Element According to Example 5 of Embodiment of Present Technology>

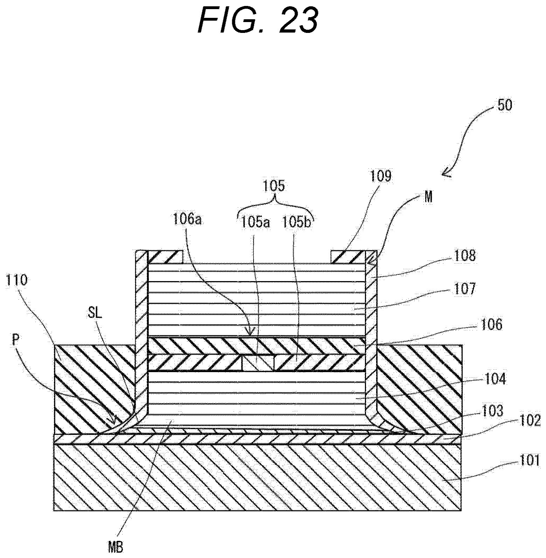

Fig. 23 is a cross-sectional view of a surface-emitting element 50 according to Example 5 of the embodiment of the present technology.

As illustrated in Fig. 23, the surface-emitting element 50 has a configuration generally similar to that of the surface-emitting element 30 according to Example 3 except that the inclined portion SL on the outer peripheral surface of the bottom portion MB of the mesa M is curved.

In the surface-emitting element 50, the inclined portion SL is inclined and curved in such a way as to be positioned more outward in the width direction of the mesa M as approaching the bottom surface of the mesa M. Here, the inclined portion SL is inclined while being curved in such a way as to protrude obliquely downward, but may be inclined while being curved in such a way as to protrude obliquely upward. A curvature of the curve of the inclined portion SL may be appropriately changed.

The surface-emitting element 50 performs an operation similar to that of the surface-emitting element 10 according to Example 1.

The surface-emitting element 50 can be manufactured by a manufacturing method generally similar to the method for manufacturing the surface-emitting element 10 according to Example 1 except that the inclined portion SL is formed by controlling an etching rate according to the progress of etching or by oblique etching.

With the surface-emitting element 50, effects generally similar to those of the surface-emitting element 30 according to Example 3 can be obtained.

### <6. Surface-Emitting Element According to Example 6 of Embodiment of Present Technology>

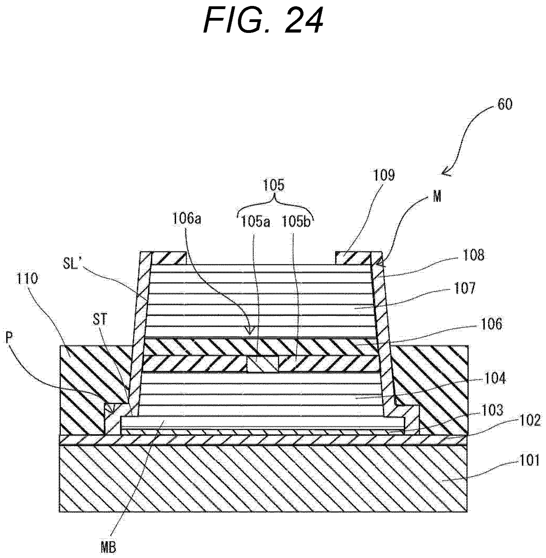

Fig. 24 is a cross-sectional view of a surface-emitting element 60 according to Example 6 of the embodiment of the present technology.

In the surface-emitting element 60, as illustrated in Fig. 24, the mesa M has a configuration similar to that of the surface-emitting element 10 according to Example 1 except that the outer peripheral surface of the part other than the bottom portion MB (the upper part of the bottom portion MB) has another inclined portion SL' that circles around the light-emitting region 106a in plan view and that is inclined in such a way as to be positioned more outward in the width direction of the mesa M (intersecting the stacking direction) as approaching the bottom surface of the mesa M.

The surface-emitting element 60 performs an operation similar to that of the surface-emitting element 10 according to Example 1.

The surface-emitting element 60 can be manufactured by a manufacturing method generally similar to the method for manufacturing the surface-emitting element 10 according to Example 1 except that the another inclined portion SL' is formed by controlling the etching rate according to the progress of etching or by oblique etching.

With the surface-emitting element 60, effects generally similar to those of the surface-emitting element 10 according to Example 1 can be obtained.

### <7. Surface-Emitting Element According to Example 7 of Embodiment of Present Technology>

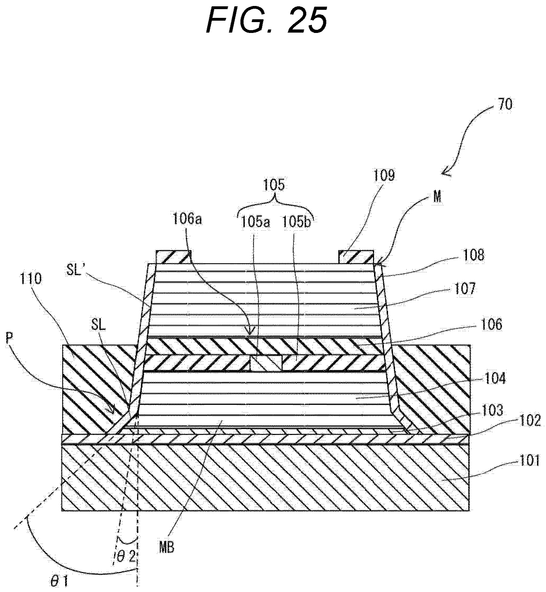

Fig. 25 is a cross-sectional view of a surface-emitting element 70 according to Example 7 of the embodiment of the present technology.

In the surface-emitting element 70, as illustrated in Fig. 25, the mesa M has a configuration similar to that of the surface-emitting element 30 according to Example 3 except that the outer peripheral surface of the part other than the bottom portion MB (the upper part of the bottom portion MB) has another inclined portion SL' that circles around the light-emitting region 106a in plan view and that is inclined in such a way as to be positioned more outward in the width direction of the mesa M (intersecting the stacking direction) as approaching the bottom surface of the mesa M.

An inclination angle θ1 of the inclined portion SL with respect to the stacking direction is larger than an inclination angle θ2 of the another inclined portion SL' with respect to the stacking direction. The inclination angle θ1 is, for example, preferably 10° or more, more preferably 20° or more, more preferably 30° or more, more preferably 40° or more, and most preferably 45°. The inclination angle θ1 is preferably 80° or less, more preferably 70° or less, more preferably 60° or less, more preferably 50° or less, and most preferably 45°. The inclination angle θ2 is, for example, preferably less than 45°, more preferably less than 40°, more preferably less than 30°, more preferably less than 20°, more preferably less than 10°, and more preferably less than 5°. Note that at least one of the inclination angles θ1 and 82 is not limited to constant, and may change gradually or stepwise, or may be essentially arc-shaped, instead.

The surface-emitting element 70 performs an operation similar to that of the surface-emitting element 10 according to Example 1.

The surface-emitting element 70 can be manufactured by a manufacturing method generally similar to the method for manufacturing the surface-emitting element 10 according to Example 1 except that the another inclined portion SL' and the inclined portion SL are formed by controlling the etching rate according to the progress of etching or by oblique etching.

With the surface-emitting element 70, effects generally similar to those of the surface-emitting element 30 according to Example 3 can be obtained.

### <8. Surface-Emitting Element According to Example 8 of Embodiment of Present Technology>

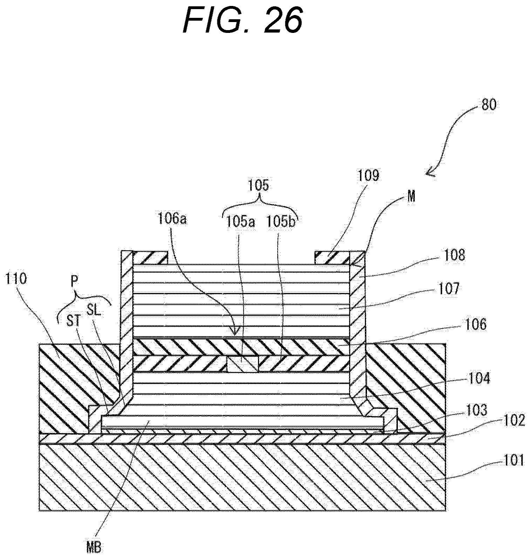

Fig. 26 is a cross-sectional view of a surface-emitting element 80 according to Example 8 of the embodiment of the present technology.

As illustrated in Fig. 26, the surface-emitting element 80 has a configuration generally similar to those of the surface-emitting elements 20 and 40 according to Examples 2 and 4 except that the convex portion P has a step ST and an inclined portion SL.

The step ST and the inclined portion SL have different positions in the height direction and the width direction of the mesa M. More specifically, the step ST is located at a lower position than (below) the inclined portion SL in the height direction of the mesa M, and the step ST is located outside the inclined portion SL in the width direction (for example, radial direction) of the mesa M. That is, the closer the step ST and the inclined portion SL are to the bottom surface of the mesa M (for example, the step ST), the more outward in the width direction of the mesa M.

An inclination angle θ of the inclined portion SL with respect to the stacking direction is, for example, preferably 10° or more, more preferably 20° or more, more preferably 30° or more, more preferably 40° or more, and most preferably 45°. The inclination angle θ is preferably 80° or less, more preferably 70° or less, more preferably 60° or less, more preferably 50° or less, and most preferably 45°.

The surface-emitting element 80 performs an operation similar to that of the surface-emitting element 10 according to Example 1.

The surface-emitting element 80 can be manufactured by a manufacturing method generally similar to the method for manufacturing the surface-emitting element 20 according to Example 2 except that the inclined portion SL is formed by controlling the etching rate according to the progress of etching or by oblique etching.

With the surface-emitting element 80, effects generally similar to those of the surface-emitting elements 20 and 40 according to Examples 2 and 4 can be obtained.

### <9. Surface-Emitting Element According to Example 9 of Embodiment of Present Technology>

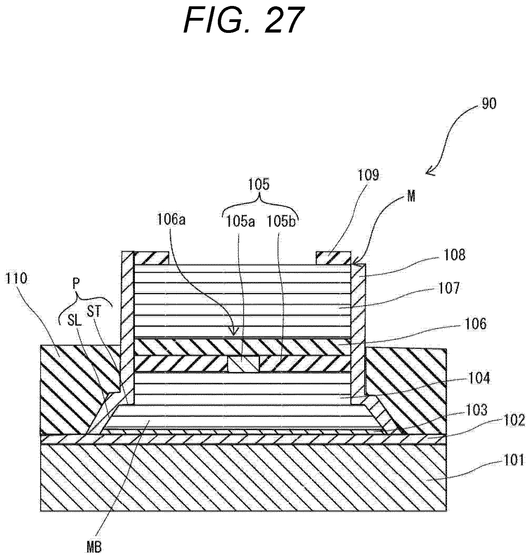

Fig. 27 is a cross-sectional view of a surface-emitting element 90 according to Example 9 of the embodiment of the present technology.

As illustrated in Fig. 27, the surface-emitting element 90 has a configuration generally similar to that of the surface-emitting element 80 according to Example 8 except that a positional relationship between the step ST and the inclined portion SL is different (reversed).

The step ST and the inclined portion SL have different positions in the height direction and the width direction of the mesa M. More specifically, the inclined portion SL is located at a lower position than (below) the step ST in the height direction of the mesa M, and the inclined portion SL is located outside the step ST in the width direction (for example, radial direction) of the mesa M. That is, the closer the step ST and the inclined portion SL are to the bottom surface of the mesa M (for example, the inclined portion SL), the more outward in the width direction of the mesa M.

An inclination angle θ of the inclined portion SL with respect to the stacking direction is, for example, preferably 10° or more, more preferably 20° or more, more preferably 30° or more, more preferably 40° or more, and most preferably 45°. The inclination angle θ is preferably 80° or less, more preferably 70° or less, more preferably 60° or less, more preferably 50° or less, and most preferably 45°.

The surface-emitting element 90 performs an operation similar to that of the surface-emitting element 10 according to Example 1.

The surface-emitting element 90 can be manufactured by a manufacturing method generally similar to the method for manufacturing the surface-emitting element 20 according to Example 2 except that the inclined portion SL is formed by controlling the etching rate according to the progress of etching or by oblique etching.

With the surface-emitting element 90, effects generally similar to those of the surface-emitting elements 20 and 40 according to Examples 2 and 4 can be obtained.

### <10. Surface-Emitting Element According to Example 10 of Embodiment of Present Technology>

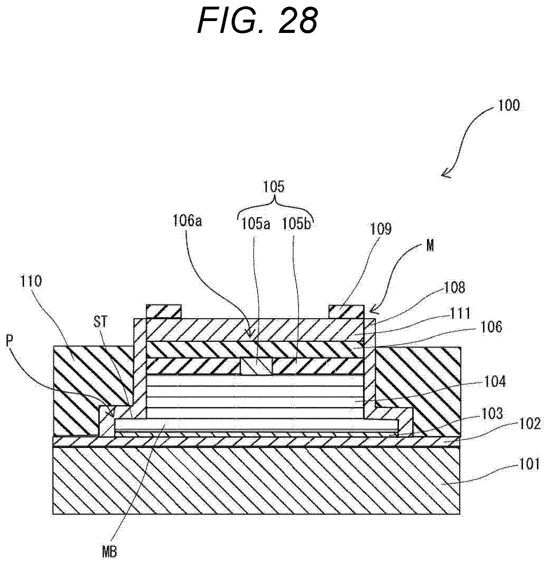

Fig. 28 is a cross-sectional view of a surface-emitting element 100 according to Example 10 of the embodiment of the present technology.

The surface-emitting element 100 has a configuration generally similar to that of the surface-emitting element 10 according to Example 1 except that it is a light-emitting diode (LED) of a front surface emission type.

In the surface-emitting element 100, the second semiconductor structure includes a cladding layer 111 (for example, an n-AlGaAs layer) instead of the second semiconductor multilayer mirror 107.

In the surface-emitting element 100, combined light of light emitted upward from the light-emitting layer 106 and light emitted downward from the light-emitting layer 106 and reflected upward from the first semiconductor multilayer mirror 104 is emitted upward from the mesa M (the front surface side of the substrate 101).

The surface-emitting element 100 can be manufactured by a manufacturing method similar to the method for manufacturing the surface-emitting element 10 according to Example 1 except that the cladding layer 111 is stacked instead of the second semiconductor multilayer mirror 107 when the multilayer body is generated.

With the surface-emitting element 100, a high-power LED of the front surface emission type that produces effects similar to those of the surface-emitting element 10 according to Example 1 can be provided.

### <11. Surface-Emitting Element According to Example 11 of Embodiment of Present Technology>

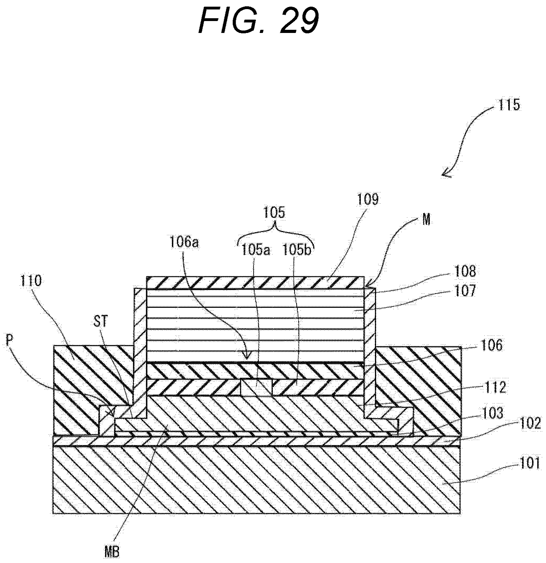

Fig. 29 is a cross-sectional view of a surface-emitting element 115 according to Example 11 of the embodiment of the present technology.

The surface-emitting element 115 has a configuration generally similar to that of the surface-emitting element 10 according to Example 1 except that it is a light-emitting diode (LED) of a back surface emission type.

In the surface-emitting element 115, the first semiconductor structure includes a cladding layer 112 (for example, a p-AlGaAs layer) instead of the first semiconductor multilayer mirror 104.

In the surface-emitting element 115, the cathode electrode 109 is provided at the top of the mesa M as a blanket layer. In this case, the cathode electrode 109 and the second semiconductor multilayer mirror 107 can constitute a hybrid mirror.

In the surface-emitting element 115, combined light of light emitted downward from the light-emitting layer 106 and light emitted upward from the light-emitting layer 106 and reflected downward from the second semiconductor multilayer mirror 107 is emitted downward from the substrate 101 (the back surface side of the substrate 101).

The surface-emitting element 115 can be manufactured by a manufacturing method similar to the method for manufacturing the surface-emitting element 10 according to Example 1 except that the cladding layer 112 is stacked instead of the first semiconductor multilayer mirror 104 when the multilayer body is generated.

With the surface-emitting element 115, a high-power LED of the back surface emission type that produces effects similar to those of the surface-emitting element 10 according to Example 1 can be provided.

### <12. Surface-Emitting Element According to Example 12 of Embodiment of Present Technology>

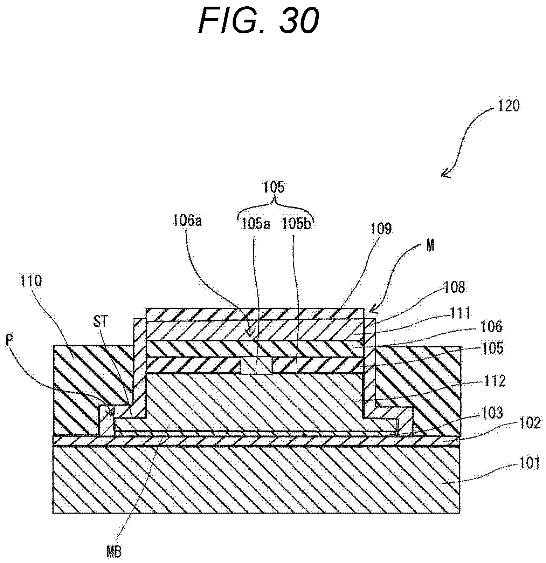

Fig. 30 is a cross-sectional view of a surface-emitting element 120 according to Example 12 of the embodiment of the present technology.

The surface-emitting element 120 has a configuration generally similar to that of the surface-emitting element 10 according to Example 1 except that it is a light-emitting diode (LED) of the back surface emission type.

In the surface-emitting element 120, the second semiconductor structure includes a cladding layer 111 (for example, an n-AlGaAs layer) instead of the second semiconductor multilayer mirror 107, and the first semiconductor structure includes a cladding layer 112 (for example, a p-AlGaAs layer) instead of the first semiconductor multilayer mirror 104.

In the surface-emitting element 120, the cathode electrode 109 is provided at the top of the mesa M as a blanket layer and also functions as a metal mirror.

In the surface-emitting element 120, combined light of light emitted downward from the light-emitting layer 106 and light emitted upward from the light-emitting layer 106 and reflected downward from the cathode electrode 109 is emitted downward from the substrate 101 (the back surface side of the substrate 101).

The surface-emitting element 120 can be manufactured by a manufacturing method similar to the method for manufacturing the surface-emitting element 10 according to Example 1 except that the cladding layer 112 is stacked instead of the first semiconductor multilayer mirror 104 and the cladding layer 111 is stacked instead of the second semiconductor multilayer mirror 107 when the multilayer body is generated.

With the surface-emitting element 120, a high-power LED of the back surface emission type that produces effects similar to those of the surface-emitting element 10 according to Example 1 can be provided.

### <13. Surface-Emitting Element According to Example 13 of Embodiment of Present Technology>

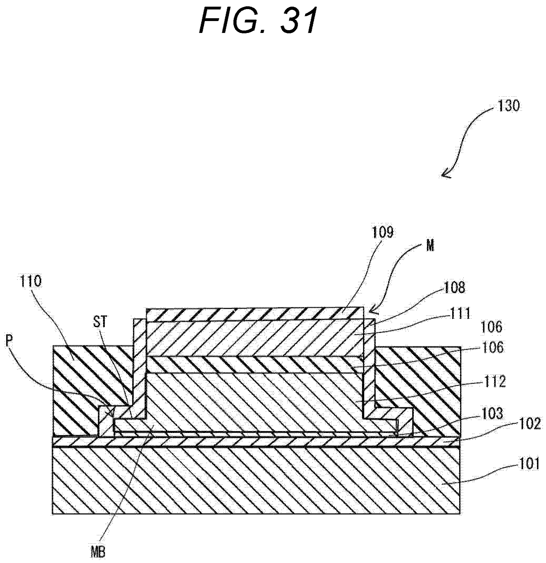

Fig. 31 is a cross-sectional view of a surface-emitting element 130 according to Example 13 of the embodiment of the present technology.

The surface-emitting element 130 has a configuration generally similar to that of the surface-emitting element 10 according to Example 1 except that it is a light-emitting diode (LED) of the back surface emission type.

In the surface-emitting element 130, the second semiconductor structure includes a cladding layer 111 (for example, an n-AlGaAs layer) instead of the second semiconductor multilayer mirror 107, and the first semiconductor structure includes a cladding layer 112 (for example, a p-AlGaAs layer) instead of the first semiconductor multilayer mirror 104.

The surface-emitting element 130 does not include the oxide confinement layer 105.

In the surface-emitting element 130, the cathode electrode 109 is provided at the top of the mesa M as a blanket layer and also functions as a metal mirror.

In the surface-emitting element 130, combined light of light emitted downward from the light-emitting layer 106 and light emitted upward from the light-emitting layer 106 and reflected downward from the cathode electrode 109 is emitted downward from the substrate 101 (the back surface side of the substrate 101).

The surface-emitting element 130 can be manufactured by a manufacturing method similar to the method for manufacturing the surface-emitting element 10 according to Example 1 except that the cladding layer 112 is stacked instead of the first semiconductor multilayer mirror 104, the cladding layer 111 is stacked instead of the second semiconductor multilayer mirror 107, and the oxidation layer 105S is not stacked when the multilayer body is generated.

With the surface-emitting element 130, a high-power LED of the back surface emission type that produces effects similar to those of the surface-emitting element 10 according to Example 1 can be provided.

### <14. Modifications of Present Technology>

The present technology is not limited to the above-described examples of the embodiment, and can be appropriately modified.

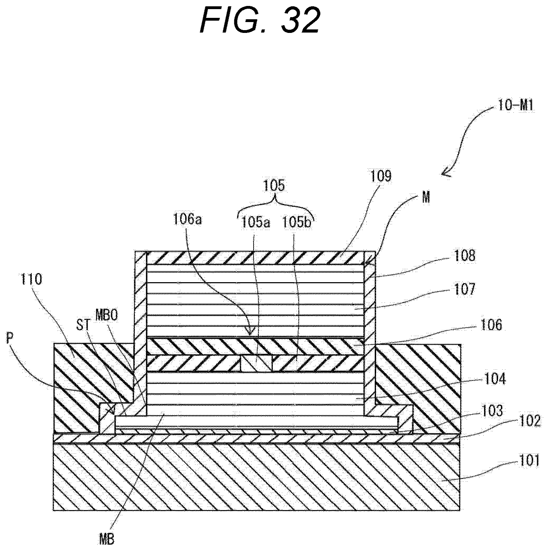

For example, as in a surface-emitting element 10-M1 according to Modification 1 of Example 1 of the embodiment of the present technology illustrated in Fig. 32, a surface-emitting laser of the back surface emission type in which a cathode electrode 109 is provided at the top of a mesa M as a blanket layer may be configured. In this case, the cathode electrode 109 and the second semiconductor multilayer mirror 107 can constitute a hybrid mirror.

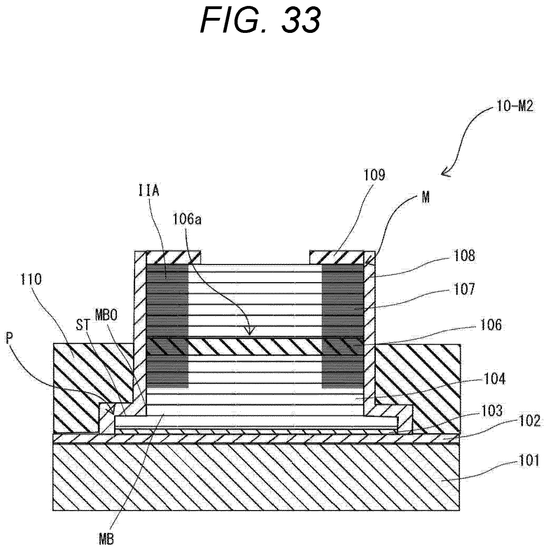

For example, as in a surface-emitting element 10-M2 according to Modification 2 of Example 1 of the embodiment of the present technology illustrated in Fig. 33, a surface-emitting laser of the front surface emission type provided with an ion implantation region IIA as a current confinement region may be configured in place of or in addition to the oxide confinement layer 105.

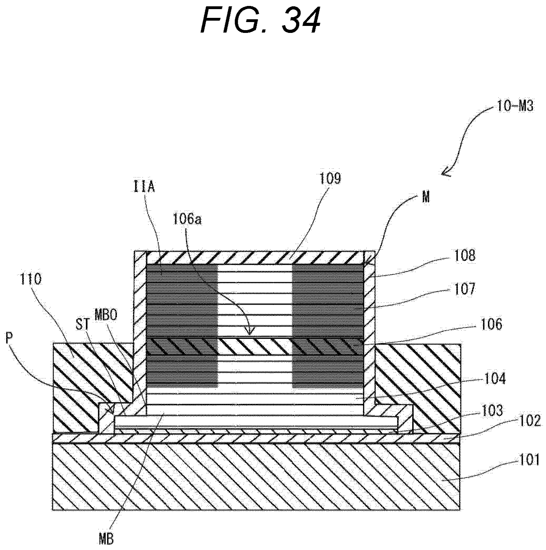

For example, as in a surface-emitting element 10-M3 according to Modification 3 of Example 1 of the embodiment of the present technology illustrated in Fig. 34, a surface-emitting laser of the back surface emission type provided with an ion implantation region IIA as a current confinement region may be configured in place of or in addition to the oxide confinement layer 105. In the surface-emitting element 10-M3, the cathode electrode 109 is provided at the top of the mesa M as a blanket layer.

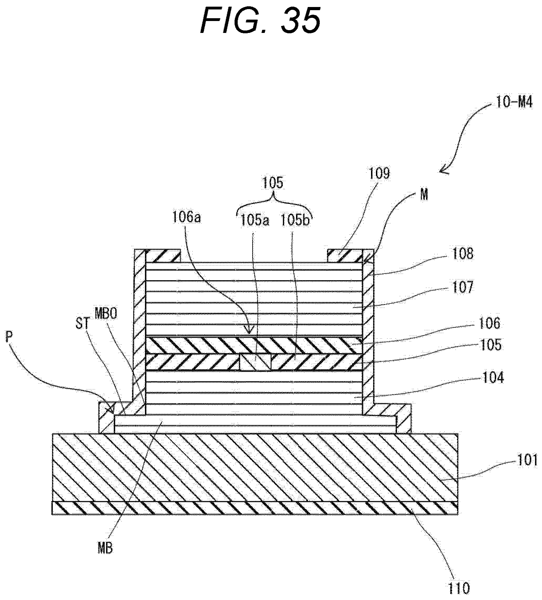

For example, as in a surface-emitting element 10-M4 according to Modification 4 of Example 1 of the embodiment of the present technology illustrated in Fig. 35, a surface-emitting laser of the front surface emission type in which an anode electrode 110 is provided on the back surface (lower surface) of the substrate 101 as a blanket layer may be configured.

In the surface-emitting element, the convex portion P may have three or more steps ST or inclined portions SL.

In the surface-emitting element, the convex portion P may have two or more steps ST and two or more inclined portions SL.

In the surface-emitting element, the convex portion P may have one step ST and two or more inclined portions SL.

In the surface-emitting element, the convex portion P may have two or more steps ST and one inclined portion.

The surface-emitting element may have a contact layer as a semiconductor layer at the top of the mesa M.

In place of or in addition to the oxide confinement layer 105 between the light-emitting layer 106 and the first semiconductor multilayer mirror 104, another oxide confinement layer 105 may be provided at least between the light-emitting layer 106 and the second semiconductor multilayer mirror 107, in the first semiconductor multilayer mirror 104, or in the second semiconductor multilayer mirror 107.

In the surface-emitting laser, a cladding layer may be provided between the light-emitting layer 106 and the first semiconductor multilayer mirror 104 and between the light-emitting layer 106 and the second semiconductor multilayer mirror 107.

A plurality of surface-emitting elements may be arranged one-dimensionally or two-dimensionally to form a surface-emitting element array.

For example, the current confinement in the surface-emitting element is not limited to the current confinement based on the oxide confinement layer 105 and/or the ion implantation region IIA. For example, current confinement may be achieved by QWI, in which a bandgap energy difference is provided between an inside and an outside of an aperture by Ga hole diffusion to confine carriers, tunnel junction, buried tunnel junction, or the like.

For example, the substrate 101 may be a Ge substrate, a Si substrate, a GaN substrate, an InP substrate, or the like. In any case, the semiconductor layer stacked on the substrate 101 is preferably appropriately selected in such a way as to be lattice-matched with the material of the substrate 101. For the surface-emitting element, a material having any light-emission wavelength included in a wavelength band of 200 to 2000 nm can be used.

At least one of the first and second structures 1S and 2S is not limited to the semiconductor multilayer mirror, but may include a mirror including one or a combination of two or more selected from a semiconductor, a dielectric, and a metal.

In the surface-emitting element according to each of the above examples and modifications, the conductivity types (p-type and n-type) of the first and second semiconductor structures may be reversed. In this case, a positional relationship between the anode electrode and the cathode electrode needs to be reversed.

A part of the configuration of the surface-emitting element according to each of the above embodiments and modifications may be combined within a range not contradictory to each other.

In each of the above embodiments and modifications, the material, conductivity type, thickness, width, numerical value, shape, size, and the like of each layer constituting the surface-emitting element can be appropriately changed within a range functioning as the surface-emitting element.

### <15. Application Example for Electronic Device>

The technology (present technology) according to the present disclosure can be applied to various products (electronic devices). For example, the technology according to the present disclosure may be implemented as an apparatus mounted on any type of mobile body such as an automobile, an electric vehicle, a hybrid electric vehicle, a motorcycle, a bicycle, a personal mobility, an airplane, a drone, a ship, or a robot, or a low power consumption device (for example, a smartphone, a smartwatch, a tablet, a mouse, or the like).

The surface-emitting element according to the present technology can also be employed as, for example, a light source of a device (for example, a printer, a copier, a projector, a head-mounted display, a head-up display, or the like) that forms or displays an image by light.

### <16. Example in Which Surface-Emitting Element Is Employed in Distance Measuring Apparatus>

An application example of the surface-emitting element 10 according to the first embodiment will be described hereinafter.

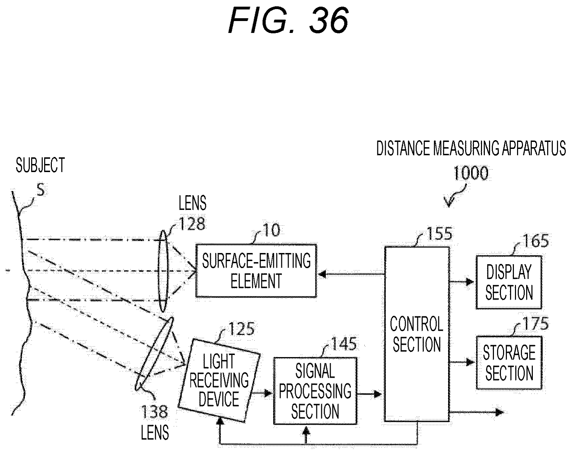

Fig. 36 illustrates an example of a schematic configuration of a distance measuring apparatus 1000 (ranging apparatus) including the surface-emitting element 10 as an example of an electronic device according to the present technology. The distance measuring apparatus 1000 measures a distance to a subject S by a time of flight (TOF) method. The distance measuring apparatus 1000 includes the surface-emitting element 10. The distance measuring apparatus 1000 includes, for example, the surface-emitting element 10, a light receiving device 125, lenses 128 and 138, a signal processing section 145, a control section 155, a display section 165, and a storage section 175.

The light receiving device 125 receives the light emitted from the surface-emitting element 10 and reflected by the subject S (object). That is, the light receiving device 125 detects the light reflected by the subject S. The lens 128 is a lens for collimating the light emitted from the surface-emitting element 10, and is, for example, a collimating lens. The lens 138 is a lens for collecting light reflected by the subject S and guiding the light to the light receiving device 125, and is, for example, a condenser lens.

The signal processing section 145 is a circuit for generating a signal corresponding to a difference between a signal input from the light receiving device 125 and a reference signal input from the control section 155. The control section 155 includes, for example, a time to digital converter (TDC). The reference signal may be a signal input from the control section 155, or may be an output signal of a detection section that directly detects the output of the surface-emitting element 10. The control section 155 is, for example, a processor that controls the surface-emitting element 10, the light receiving device 125, the signal processing section 145, the display section 165, and the storage section 175. The control section 155 is a circuit that measures the distance to the subject S on the basis of the signal generated by the signal processing section 145. The control section 155 generates a video signal for displaying information on the distance to the subject S, and outputs the video signal to the display section 165. The display section 165 displays information on the distance to the subject S on the basis of the video signal input from the control section 155. The control section 155 stores information on the distance to the subject S in the storage section 175.

In the present application example, instead of the surface-emitting element 10, any one of the surface-emitting elements 10-M1, 10-M2, 10-M3, 10-M4, 20, 30, 40, 50, 60, 70, 80, 90, 100, 115, 120, and 130 may be employed for the distance measuring apparatus 1000.

### <17. Example in Which Distance Measuring Apparatus Is Mounted on Mobile Body>

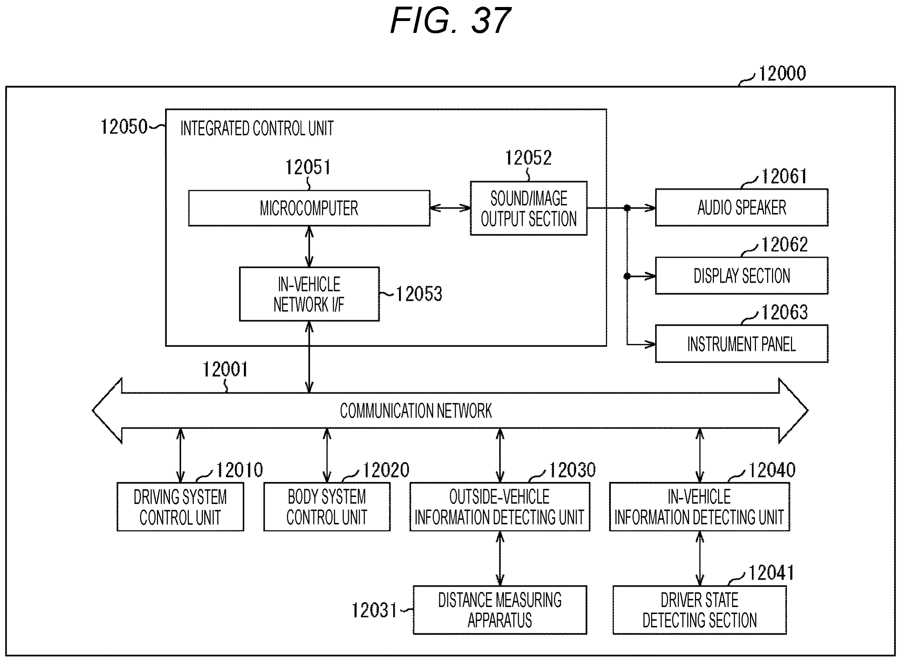

Fig. 37 is a block diagram illustrating a schematic configuration example of a vehicle control system that is an example of a mobile body control system to which the technology according to the present disclosure can be applied.

A vehicle control system 12000 includes a plurality of electronic control units connected to each other via a communication network 12001. In the example illustrated in Fig. 37, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls operation of devices related to a driving system of a vehicle in accordance with various programs. For example, the driving system control unit 12010 functions as a control device for a driving force generating device for generating driving force of the vehicle, such as an internal combustion engine or a driving motor, a driving force transmitting mechanism for transmitting the driving force to wheels, a steering mechanism for adjusting a steering angle of the vehicle, a braking device for generating braking force of the vehicle, and the like.

The body system control unit 12020 controls operation of various devices provided to a vehicle body in accordance with various programs. For example, the body system control unit 12020 functions as a control device for a keyless entry system, a smart key system, a power window device, or various lamps such as a headlamp, a back-up lamp, a brake lamp, a turn indicator, or a fog lamp. In this case, a radio wave transmitted from a mobile device that substitutes for a key or signals of various switches may be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, a distance measuring apparatus 12031 is connected to the outside-vehicle information detecting unit 12030. The distance measuring apparatus 12031 includes the distance measuring apparatus 1000 described above. The outside-vehicle information detecting unit 12030 causes the distance measuring apparatus 12031 to measure a distance to an object (subject S) outside the vehicle, and acquires distance data acquired by the measurement. The outside-vehicle information detecting unit 12030 may perform object detection processing of detecting a person, a vehicle, an obstacle, a sign, or the like on the basis of the acquired distance data.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle, the information being acquired by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS), the functions including vehicle collision avoidance or shock mitigation, following driving based on a following distance, vehicle speed maintaining driving, vehicle collision warning, vehicle lane departure warning, and the like.

Furthermore, the microcomputer 12051 can perform cooperative control intended for automated driving in which the vehicle travels autonomously without depending on the driver's operation, or the like, by controlling the driving force generating device, the steering mechanism, the braking device, or the like on the basis of the information about surroundings of the vehicle, the information being acquired by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent glare such as switching from high beam to low beam, by controlling the headlamp in accordance with a position of a preceding vehicle or an oncoming vehicle detected by the outside-vehicle information detecting unit 12030.

The sound/image output section 12052 transmits an output signal of at least one of a sound or an image to an output device capable of visually or auditorily notifying an occupant of the vehicle or the outside of the vehicle of information. In the example of Fig. 37, an audio speaker 12061, a display section 12062, and an instrument panel 12063 are illustrated as output devices. The display section 12062 may, for example, include at least one of an on-board display or a head-up display.

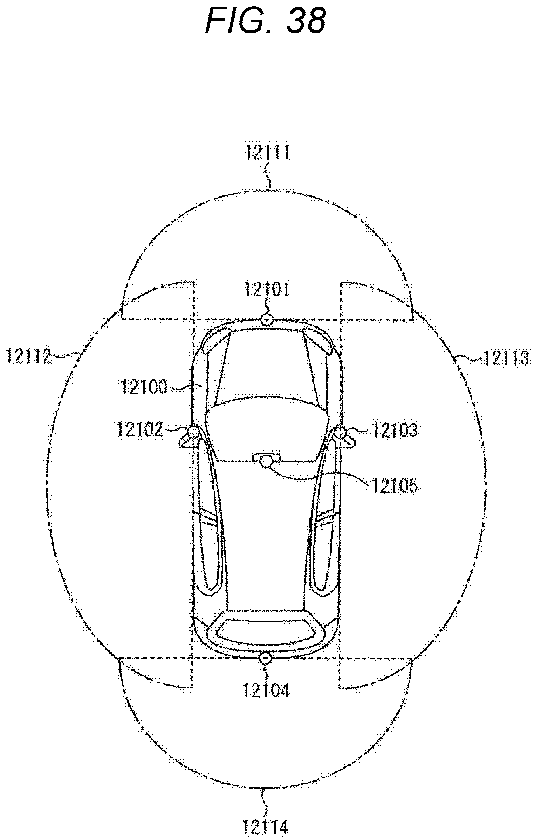

Fig. 38 is a diagram illustrating an example of installation positions of the distance measuring device 12031.

In Fig. 38, a vehicle 12100 includes distance measuring devices 12101, 12102, 12103, 12104, and 12105 as the distance measuring device 12031.

For example, the distance measuring apparatuses 12101, 12102, 12103, 12104, and 12105 are provided at positions such as a front nose, sideview mirrors, a rear bumper, a back door, an upper portion of a windshield in a vehicle interior, and the like, of the vehicle 12100. The distance measuring apparatus 12101 provided at the front nose and the distance measuring apparatus 12105 provided at the upper portion of the windshield in the vehicle interior mainly acquire data of the front side of the vehicle 12100. The distance measuring apparatuses 12102 and 12103 provided at the sideview mirrors mainly acquire data of the sides of the vehicle 12100. The distance measuring apparatus 12104 provided at the rear bumper or the back door mainly acquires data of the rear side of the vehicle 12100. The data of the front side acquired by the distance measuring apparatuses 12101 and 12105 is mainly used to detect a preceding vehicle, a pedestrian, an obstacle, a traffic light, a traffic sign, or the like.

Note that Fig. 38 illustrates an example of detection ranges of the distance measuring devices 12101 to 12104. A detection range 12111 indicates a detection range of the distance measuring apparatus 12101 provided at the front nose, detection ranges 12112 and 12113 indicate detection ranges of the distance measuring apparatuses 12102 and 12103 provided at the sideview mirrors, respectively, and a detection range 12114 indicates a detection range of the distance measuring apparatus 12104 provided at the rear bumper or the back door.

For example, the microcomputer 12051 may obtain a distance to each three-dimensional object within the detection ranges 12111 to 12114 and a temporal change in the distance (relative speed with respect to the vehicle 12100) on the basis of the distance data obtained from the distance measuring apparatuses 12101 to 12104, whereby particularly the nearest three-dimensional object present on a traveling path of the vehicle 12100, which travels in substantially the same direction as the vehicle 12100 at a predetermined speed (for example, equal to or more than 0 km/h), may be extracted as a preceding vehicle. Moreover, the microcomputer 12051 can set a following distance to be maintained relative to a preceding vehicle in advance, and perform automatic brake control (including following stop control), automatic acceleration control (including following start control), or the like. It is thus possible to perform cooperative control intended for automated driving in which the vehicle travels autonomously without depending on the driver's operation, or the like.

For example, on the basis of the distance data obtained from the distance measuring apparatuses 12101 to 12104, the microcomputer 12051 can extract three-dimensional object data regarding three-dimensional objects while classifying into two-wheeled vehicles, standard-sized vehicles, large-sized vehicles, pedestrians, and other three-dimensional objects such as utility poles, and use the three-dimensional object data for automatic avoidance of obstacles. For example, the microcomputer 12051 identifies obstacles around the vehicle 12100 as obstacles that the driver of the vehicle 12100 can recognize visually and obstacles that are difficult for the driver of the vehicle to recognize visually. Then, the microcomputer 12051 determines a collision risk indicating a risk of collision with each obstacle, and in a situation in which the collision risk is greater than or equal to a set value and there is a possibility of collision, can perform driving assistance to avoid collision by outputting a warning to the driver via the audio speaker 12061 or the display section 12062, and performing forced deceleration or avoidance steering via the driving system control unit 12010.

An example of the mobile body control system to which the technology according to the present disclosure can be applied has been described above. The technology according to the present disclosure may be applied to the distance measuring apparatus 12031 in the configuration described above.

Furthermore, the present technology may also adopt the following configurations.
(1) A surface-emitting element including:
   a first structure including a first semiconductor structure;
   a second structure including a second semiconductor structure laminated with the first structure; and
   a light-emitting layer disposed between the first and second structures and having a light-emitting region,
   in which
   a mesa including at least a part of the first semiconductor structure, the light-emitting layer, and the second semiconductor structure and having a bottom portion in the at least a part is formed, and
   an outer peripheral surface of the bottom portion has a convex portion that goes around the light-emitting region in a plan view.
(2) The surface-emitting element according to (1), in which a height of the bottom portion is 1/3 or less of a height of the mesa.
(3) The surface-emitting element according to (1) or (2), in which an outer peripheral surface of a part of the mesa other than the bottom portion does not intersect a stacking direction of the first and second structures.
(4) The surface-emitting element according to (1) or (2), in which the mesa is inclined such that an outer peripheral surface of a part other than the bottom portion is located outward in a width direction of the mesa with respect to a stacking direction of the first and second structures as approaching a bottom surface.
(5) The surface-emitting element according to any one of (1) to (4), in which at least an outer peripheral surface of the mesa is covered with a protective film.
(6) The surface-emitting element according to (5), in which the protective film is provided continuously along the convex portion on the outer peripheral surface of the bottom portion.
(7) The surface-emitting element according to (5) or (6), in which a peripheral region of the mesa of the first structure and at least a part of the protective film provided on the convex portion are covered with a conductive film.
(8) The surface-emitting element according to (7), in which the conductive film includes conductive plating.
(9) The surface-emitting element according to any one of (1) to (8), in which the convex portion includes a step that circles around the light-emitting region in plan view and/or an inclined portion that circles around the light-emitting region in plan view.
(10) The surface-emitting element according to (9), in which the convex portion includes a plurality of the steps.
(11) The surface-emitting element according to (10), in which the plurality of steps is located at different positions in a height direction and a width direction of the mesa.
(12) The surface-emitting element according to any one of (9) to (11), in which the convex portion includes the inclined portion, and the inclined portion is inclined in such a way as to be positioned outward in a width direction of the mesa as approaching a bottom surface of the mesa.
(13) The surface-emitting element according to (12), in which an inclination angle of the inclined portion with respect to a stacking direction of the first and second structures is 10° or more.
(14) The surface-emitting element according to any one of (9) to (13), in which the convex portion includes a plurality of the inclined portions.
(15) The surface-emitting element according to (14), in which the plurality of steps is located at different positions in a height direction and a width direction of the mesa.
(16) The surface-emitting element according to any one of (9) to (15), in which the mesa includes another inclined portion in which an outer peripheral surface of a part other than the bottom portion circles around the light-emitting region in plan view and is inclined in such a way as to be positioned outward in a width direction of the mesa as approaching a bottom surface of the mesa.
(17) The surface-emitting element according to (16), in which the convex portion includes the inclined portion, and an inclination angle of the inclined portion with respect to a stacking direction of the first and second structures is larger than an inclination angle of the another inclined portion.
(18) The surface-emitting element according to any one of (9) to (17), in which the convex portion includes the step and the inclined portion.
(19) The surface-emitting element according to (18), in which the step and the inclined portion are located at different positions in a height direction and a width direction of the mesa.
(20) The surface-emitting element according to any one of (1) to (19), in which the first structure includes a substrate on a side of the first semiconductor structure opposite a light-emitting layer side, and the first semiconductor structure includes at least one semiconductor layer arranged between the substrate and the light-emitting layer, a contact layer arranged between the substrate and the at least one semiconductor layer, and an etching stop layer arranged between the at least one semiconductor layer and the contact layer.
(21) The surface-emitting element according to any one of (1) to (20), in which the first structure and/or the second structure is provided with a current confinement area that sets the light-emitting region.
(22) The surface-emitting element according to any one of (1) to (21), in which at least one of the first and second semiconductor structures includes a semiconductor multilayer mirror.
(23) An electronic device including:
   a surface-emitting element including:
   a first structure including a first semiconductor structure;
   a second structure stacked with the first structure and including a second semiconductor structure; and
   a light-emitting layer arranged between the first and second structures and including a light-emitting region, in which
   a mesa including at least a part of the first semiconductor structure, the light-emitting layer, and the second semiconductor structure and having a bottom portion in the at least a part is formed, and
   an outer peripheral surface of the bottom portion has a convex portion that circles around the light-emitting region in plan view.
(24) A method for manufacturing a surface-emitting element including a step of stacking a first semiconductor structure, a light-emitting layer, and a second semiconductor structure on a substrate in this order to generate a multilayer body, a step of etching the multilayer body to form a first mesa, and a step of etching the first mesa to form a second mesa M2 including at least a part of a convex portion circling around an outer peripheral surface of a bottom portion.
(25) The method for manufacturing a surface-emitting element according to (24), in which, in the step of generating a multilayer body, a contact layer, an etching stop layer, and a first semiconductor multilayer mirror included in the first semiconductor structure are stacked on the substrate in this order.

### REFERENCE SIGNS LIST

10, 10-M1, 10-M2, 10-M3, 10-M4, 20, 30, 40, 50, 60, 70, 80, 90, 100, 115, 120, 130 Surface-emitting element
101 Substrate
102 Contact layer
103 Etching stop layer
104 First semiconductor multilayer mirror (semiconductor multilayer mirror, semiconductor layer)
105b Oxidized region (current confinement region)
106 Light-emitting layer
106a Light-emitting region
107 Second semiconductor multilayer mirror (semiconductor multilayer mirror)
108 Insulating film (protective film)
110 Anode electrode (conductive film)
112 Cladding layer (semiconductor layer)
1S First structure
2S Second structure
SS1 First semiconductor structure
SS2 Second semiconductor structure
M Mesa
MB Bottom portion of mesa
MBO Outer peripheral surface of bottom portion of mesa
H Height of mesa
H_{B} Height of bottom portion of mesa
P Convex portion
ST Step
ST1 First step (step)
ST2 Second step (step)
SL Inclined portion
SL1 First inclined portion (inclined portion)
SL2 Second inclined portion (inclined portion)
SL' Another inclined portion
IIA Ion implantation region (current confinement region)
θ Inclination angle
θ1 Inclination angle of inclined portion with respect to stacking direction
θ2 Inclination angle of another inclined portion with respect to stacking direction

## Claims

1. A surface-emitting element comprising:
a first structure including a first semiconductor structure;
a second structure including a second semiconductor structure stacked with the first structure; and
a light-emitting layer arranged between the first and second structures and including a light-emitting region, wherein
a mesa including at least a part of the first semiconductor structure, the light-emitting layer, and the second semiconductor structure and having a bottom portion in the at least a part is formed, and
an outer peripheral surface of the bottom portion has a convex portion that circles around the light-emitting region in plan view.

2. The surface-emitting element according to claim 1, wherein a height of the bottom portion is 1/3 or less of a height of the mesa.

3. The surface-emitting element according to claim 1, wherein an outer peripheral surface of a part of the mesa other than the bottom portion does not intersect a stacking direction of the first and second structures.

4. The surface-emitting element according to claim 1, wherein an outer peripheral surface of a part of the mesa other than the bottom portion intersects a stacking direction of the first and second structures.

5. The surface-emitting element according to claim 1, wherein at least an outer peripheral surface of the mesa is covered with a protective film.

6. The surface-emitting element according to claim 5, wherein the protective film is provided continuously along the convex portion on the outer peripheral surface of the bottom portion.

7. The surface-emitting element according to claim 6, wherein a peripheral region of the mesa of the first structure and at least a part of the protective film provided on the convex portion are covered with a conductive film.

8. The surface-emitting element according to claim 7, wherein the conductive film includes conductive plating.

9. The surface-emitting element according to claim 1, wherein the convex portion includes a step that circles around the light-emitting region in plan view and/or an inclined portion that circles around the light-emitting region in plan view.

10. The surface-emitting element according to claim 9, wherein the convex portion includes a plurality of the steps.

11. The surface-emitting element according to claim 9, wherein
the convex portion includes the inclined portion, and
the inclined portion is inclined in such a way as to be positioned outward in a width direction of the mesa as approaching a bottom surface of the mesa.

12. The surface-emitting element according to claim 11, wherein an inclination angle of the inclined portion with respect to a stacking direction of the first and second structures is 10° or more.

13. The surface-emitting element according to claim 9, wherein the convex portion includes a plurality of the inclined portions.

14. The surface-emitting element according to claim 9, wherein the mesa includes another inclined portion in which an outer peripheral surface of a part other than the bottom portion circles around the light-emitting region in plan view and is inclined in such a way as to be positioned outward in a width direction of the mesa as approaching a bottom surface of the mesa.

15. The surface-emitting element according to claim 14, wherein
the convex portion includes the inclined portion, and
an inclination angle of the inclined portion with respect to a stacking direction of the first and second structures is larger than an inclination angle of the another inclined portion.

16. The surface-emitting element according to claim 9, wherein the convex portion includes the step and the inclined portion.

17. The surface-emitting element according to claim 1, wherein
the first structure includes a substrate on a side of the first semiconductor structure opposite a light-emitting layer side, and
the first semiconductor structure includes:
at least one semiconductor layer arranged between the substrate and the light-emitting layer;
a contact layer arranged between the substrate and the at least one semiconductor layer; and
an etching stop layer arranged between the at least one semiconductor layer and the contact layer.

18. The surface-emitting element according to claim 1, wherein the first structure and/or the second structure is provided with a current confinement area that sets the light-emitting region.

19. The surface-emitting element according to claim 1, wherein at least one of the first and second semiconductor structures includes a semiconductor multilayer mirror.

20. An electronic device comprising:
a surface-emitting element including:
a first structure including a first semiconductor structure;
a second structure stacked with the first structure and including a second semiconductor structure; and
a light-emitting layer arranged between the first and second structures and including a light-emitting region, wherein
a mesa including at least a part of the first semiconductor structure, the light-emitting layer, and the second semiconductor structure and having a bottom portion in the at least a part is formed, and
an outer peripheral surface of the bottom portion has a convex portion that circles around the light-emitting region in plan view.
